Europäisches Patentamt

European Patent Office

Office européen des brevets

(11) Publication number: **0 263 609**
**A2**

(12) **EUROPEAN PATENT APPLICATION**

(21) Application number: **87308266.3**

(51) Int. Cl.⁴: **G03F 7/00**

(22) Date of filing: **18.09.87**

(30) Priority: **07.10.86 JP 238273/86**
**17.10.86 JP 246691/86**
**02.12.86 JP 287466/86**
**24.04.87 JP 101194/87**
**19.05.87 JP 121727/87**
**27.05.87 JP 130424/87**
**16.06.87 JP 149681/87**

(43) Date of publication of application:
**13.04.88 Bulletin 88/15**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Yamagata, Kiyohiro**
**Seiko Epson Corporation 3-5, Owa, 3-chome**
**Suwa-shi Nagano-ken(JP)**
Inventor: **Toba, Koichi**
**Seiko Epson Corporation 3-5, Owa, 3-chome**
**Suwa-shi Nagano-ken(JP)**
Inventor: **Kobayashi, Atsushi**
**Seiko Epson Corporation 3-5, Owa, 3-chome**
**Suwa-shi Nagano-ken(JP)**
Inventor: **Abe, Nobumasa**
**Seiko Epson Corporation 3-5, Owa, 3-chome**
**Suwa-shi Nagano-ken(JP)**
Inventor: **Watanabe, Koji**
**Seiko Epson Corporation 3-5, Owa, 3-chome**
**Suwa-shi Nagano-ken(JP)**

(74) Representative: **Miller, Joseph et al**
**J. MILLER & CO. Lincoln House 296-302 High**
**Holborn**
**London WC1V 7JH(GB)**

(54) **Image forming apparatus.**

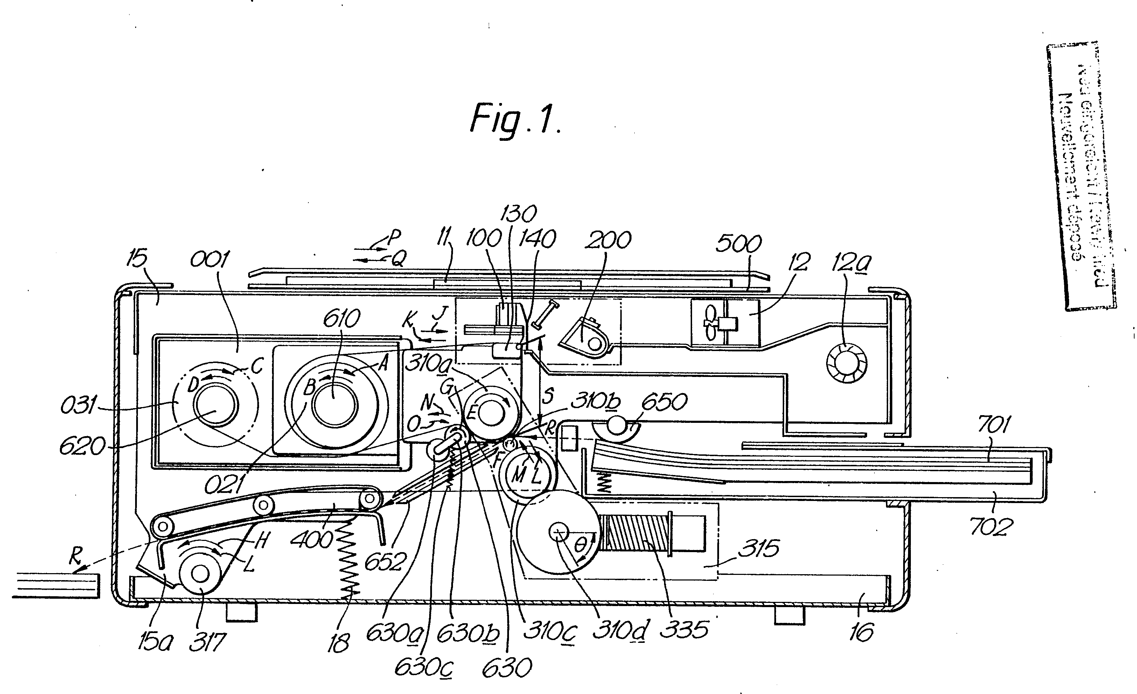

(57) Image forming apparatus comprising first storage means (001) for storing a photosensitive medium (010) having rupturable capsules which contain material part of which is adapted to form an image and part of which, on exposure to light, alters the hardness or softness of the capsules; exposing means (100) for exposing the photosensitive medium (010) to a predetermined light pattern; second storage means (702) for storing a receiver sheet (701) which is to receive the said image; and pressure means (300) for rupturing selected capsules so as to produce an image on the receiver sheet (701).  *Fig.1.*

## "IMAGE FORMING APPARATUS"

The present invention relates to an image forming apparatus which forms a latent image on a photosensitive medium by exposure and then forms a visible image corresponding to the latent image on a receiver sheet. Although the invention is not so restricted, it relates in particular to an apparatus wherein an image is formed by exposure on a web of photosensitive medium coated with microcapsules containing optically hardening or softening matter and transfer matter, and then the photosensitive medium and a receiver sheet are sandwiched between and pressed by pressure rollers to thereby form the image on the receiver sheet.

A previously known apparatus obtaining an image by exposing a photosensitive material to form an image thereon depends on the electrophotographic process or a silver halide photographic process. The electrophotographic process in a colour copier comprises applying toner powders of the three primary colours to a photosensitive drum and selectively fixing the toner powders on a record sheet according to the respective colours. The silver halide photographic process comprises forming a latent image on a photosensitive sheet and rendering the image visible by means of a wet developing process using a liquid developer, a liquid stopper and a liquid fixer.

However, the above-mentioned copying machines of the prior art have the following drawbacks. In the case of the electrophotographic process, in the first place, the tonal accuracy is low. Secondly, in a colour copier, there is a need for high precision in the sheet feeding system to prevent displacement of the colours caused by independent exposure, toner transfer, and fixing according to red, green and blue, respectively, so that the apparatus is big and expensive. Further, it is difficult to produce a clear copy because of the above-mentioned displacement of the respective colour images.

In the case of the silver halide photographic process, handling is not easy due to the wet developing process. It is, moreover, necessary to dispose of the waste solution. An offensive odour is generated by the process and the use of silver-using photographic paper causes high running costs. These are basic problems. Moreover, the development process is complicated so that weight, size, and production cost are increased.

It is therefore an object of the invention to provide an image forming apparatus which produces a picture of a good quality such as good colour reproduction, tonal accuracy and clearness. Another object of the invention is to provide an image forming apparatus which is simple, easy to handle, light, small and low in both production costs and running costs.

According, therefore, to the present invention, there is provided an image forming apparatus comprising first storage means for storing a photosensitive medium having rupturable capsules which contain material part of which is adapted to form an image and part of which, on exposure to light, alters the hardness or softness of the capsules; exposing means for exposing the photosensitive medium to a predetermined light pattern; second storage means for storing a receiver sheet which is to receive the said image and pressure means for rupturing selected capsules so as to produce an image on the receiver sheet.

The photosensitive medium and the receiver sheet may be assembled and pressed to thereby develop a panchromatic or monochromatic image on the receiver sheet.

The formation of a panchromatic image, for example, may be as follows. The photosensitive medium may comprise a substrate, microcapsules having a diameter of some micrometers being uniformly dispersed over the substrate. Each microcapsule may contain a dye precursor and optically hardening or softening matter. The dye precursor may be reacted with a developer described later on to form a colour. The optically hardening or softening matter may be reacted only with light in the wave length band of red, green and blue (hereinafter referred to as R, G, B). The receiver sheet may be coated with a developer which can react with the dye precursor of R, G, B, respectively, to develop the colours. Accordingly, when the photosensitive medium is exposed to form a colour image thereon, the optically hardening or softening matter relating to the respective wavelength may be hardened or softened according to the intensity of light. Then, the photosensitive medium may be superposed on the receiver sheet in surface contact therewith and they may be pressed against each other. As a result, microcapsules not hardened or softened are broken according to the amount of light received so that the dye precursor in the respective microcapsules flows out and reacts with the developer to form a colour image.

Accordingly, since three kinds of microcapsules corresponding to R, G, B; respectively are exposed, it is possible to expose such capsules at one exposure using light having wavelengths corresponding to all the three colours. Moreover, since each microcapsule may have a diameter of several $\mu$m, the resultant colour image may have a high resolution of about 100 dots/mm. Furthermore, receiver sheets are extremely low in production cost as compared with a photographic paper used in a silver halide photographic method because of the difference in the manner of sheet loading. The apparatus of the invention also allows dry developing, which is one of its merits.

The basic principle of colour image formation is similarly applicable to the case in which the photosensitive medium and the receiver sheets are adapted for monochromatic image formation.

Preferably, the first storage means is provided with a supply shaft around which unexposed photosensitive medium may be wound; a lightproof cartridge within which the supply shaft is mounted; a storage shaft around which exposed photosensitive medium may be wound; driving means for driving the supply shaft and storage shaft; and a cassette case body within which are mounted the storage shaft and a cartridge. The driving means may comprise a driving shaft which drives the supply shaft and the storage shaft by way of respective clutches. Preferably, an U-shaped member, for supporting a loop of the photosensitive medium, is itself supported by and protrudes from the cassette·case body.

The pressure means in operation preferably presses the photosensitive medium against the receiver sheet so that the latter receives the image.

The pressure means preferably comprises at least one pair of pressure rollers. Thus one pressure roller of the or each said pair of rollers may have a smaller diameter than the other.

At least one of the pressure rollers may be engaged or engageable with a back-up roller.

Relative movement effecting means may be provided for effecting relative movement towards and away from each other of pressure rollers between which the photosensitive medium and the receiver sheet may be passed.

The pressure means may comprise a detector which is arranged to detect the presence of a predetermined portion of the receiver sheet, the said detector controlling operation of the relative movement effecting means.

The relative movement effecting means may effect relative movement of plates in which the pressure rollers are rotatably mounted.

At least one of the pressure rollers may be supported by plates at least one of which is removable to assist introduction of the photosensitive medium into the pressure means.

The second storage means may be provided with detector means for detecting the width and length of the receiver sheet, the detector means controlling the length of the exposure.

A thermal treatment means may be provided for thermally treating the receiver sheet which has received the said image. The thermal treatment means may be arranged to heat at least the image-formed area of the receiver sheet to a temperature higher than the softening point of the matter forming the image.

There are preferably driving means for transporting the receiver sheet through the thermal treatment means in contact with the non-softened area of the receiver sheet.

The invention is illustrated, merely by way of example, in the accompanying drawings, in which:-

Figure 1 is a front sectional view of an image forming apparatus according to one embodiment of the present invention;

Figure 2 is a sectional side view of the image forming apparatus of Figure 1;

Figure 3 is a top plan view of the image forming apparatus of Figure 1;

Figure 4 is a sectional view of a cassette for storing a photosensitive medium, the said cassette forming part of the apparatus of Figure 1;

Figure 5 is a partially cut-away perspective view of the cassette shown in Figure 4;

Figure 6 is a sectional view of a cassette for storing a photosensitive medium according to another embodiment of the present invention;

Figure 7 is a perspective view of a cassette for storing a photosensitive medium according to yet a further embodiment of the present invention;

Figure 8 is a broken away sectional view showing the nip of pressure rollers of a pressure developer forming part of the apparatus of Figure 1;

Figure 9 is a main sectional view showing a pressure part of a pressure developer forming part of the apparatus of Figure 1;

Figure 9a is a broken away perspective view of part of the structure shown in Figure 9;

Figure 10 is a plan view of the structure shown in Figure 9;

Figure 11 is a side view of the structure shown in Figure 9;

Figure 12 is a bottom view of the structure shown in Figure 11;

Figure 13 is a sectional view taken along the line A-A' of Figure 9;

Figure 14 is a bottom view of the structure shown in Figure 9;

Figure 15 is a schematic view showing the arrangement of a detector for controlling the pressure timing in the said pressure developer;

Figure 16 is a graph showing the relationship between the transportation time (including the start and stop positional relationship of a motor for rotating an application shaft) and the load in a pressure developer as used in the present invention and in the prior art;

Figure 17 is a main sectional view showing a second embodiment of the pressure part of a pressure developer;

Figure 18 is a left side view of the structure shown in Figure 17;

Figure 19 is a right-hand side view of the structure shown in Figure 17;

Figure 20 is a sectional view taken along the line C-C' of Figure 19;

Figure 21 is a schematic view of a third embodiment of a pressure part mechanism in a pressure developer;

Figure 22 is a schematic view of a fourth embodiment of a pressure part mechanism in a pressure developer;

Figure 23 is a part-sectional view of one embodiment of the structure of the pressure rollers which may be employed in a pressure developer;

Figure 24 is a sectional view taken along the line C-C' of Figure 23;

Figure 25 is a sectional view of the structure shown in Figure 23 at the pressure developing time;

Figure 26(a) is a schematic view showing the condition of a top pressure roller at the pressure developing time;

Figure 26(b) is a schematic view showing the condition of intermediate and bottom pressure rollers at the pressure developing time;

Figure 27 is a sectional view of the bottom pressure roller having a curve rate R;

Figure 28 is a part-sectional view showing a second embodiment of the structure of the pressure rollers in a pressure developer;

Figure 29 is a sectional view taken along the line C-C' of Figure 28;

Figure 30 is a part-sectional view showing a third embodiment of the structure of the pressure rollers in a pressure developer;

Figure 31 is a sectional view taken along the line D-D' of Figure 30;

Figure 32 is a graph showing the relationship between the feed speed and the load in order to achieve an image with an optically reflective density of 2 or more in the respective cases of two pressure rollers with $\phi$ 5mm, two pressure rollers with $\phi$ 10mm, and two pressure rollers with $\phi$ 50mm;

Figure 33 is a graph showing the relationship between the feed speed and the load in order to achieve an image without unevenness in the respective cases of two pressure rollers with $\phi$ 5mm, two pressure rollers with $\phi$ 10mm and two pressure rollers with $\phi$ 50mm;

Figure 34 is a graph showing the relationship between the diameter of the pressure roller and the feed speed when the maximum load is applied to the pressure rollers;

Figure 35 is a plan view showing four sizes of receiver sheet;

Figure 36 is a top plan view of one embodiment of a receiver sheet cassette forming part of the apparatus of Figure 1;

Figure 37 is a sectional view taken along the line E-E' of Figure 36;

Figure 38 is a sectional view taken along the line F-F' of Figure 37;

Figure 39 is a sectional side view of one embodiment of a thermal treatment means forming part of the apparatus of Figure 1;

Figure 40 is a bottom sectional view of the embodiment shown in Figure 39;

Figure 41 is a side view of the embodiment shown in Figure 39;

Figure 42 is a sectional view of a fixing structure of heaters forming part of the embodiment shown in Figure 39;

Figure 43 is a graph showing the temperature-resistance characteristic of a heater which may be used in the present invention;

Figure 44(a) is a top plan view of another embodiment of a thermal treatment means which may be used in the present invention;

Figure 44(b) is a side view of the embodiment shown in Figure 44(a);

Figure 45(a) is a top plan view of a further embodiment of a thermal treatment means which may be used in the present invention;

Figure 45(b) is a side view of the embodiment shown in Figure 45(a);

Figure 46 is a sectional view of a mechanism for rotating a supply shaft forming part of the apparatus of Figure 1;

Figure 47 is a sectional view taken along the line A-A' of Figure 46; and

Figure 48 is a bottom view of the embodiment shown in Figure 46.

Terms such as "left", "right", "top" and "front", as used in the description below, are to be understood to refer to directions as seen in the respective drawings.

One embodiment of the present invention is described below with reference to the accompanying drawings.

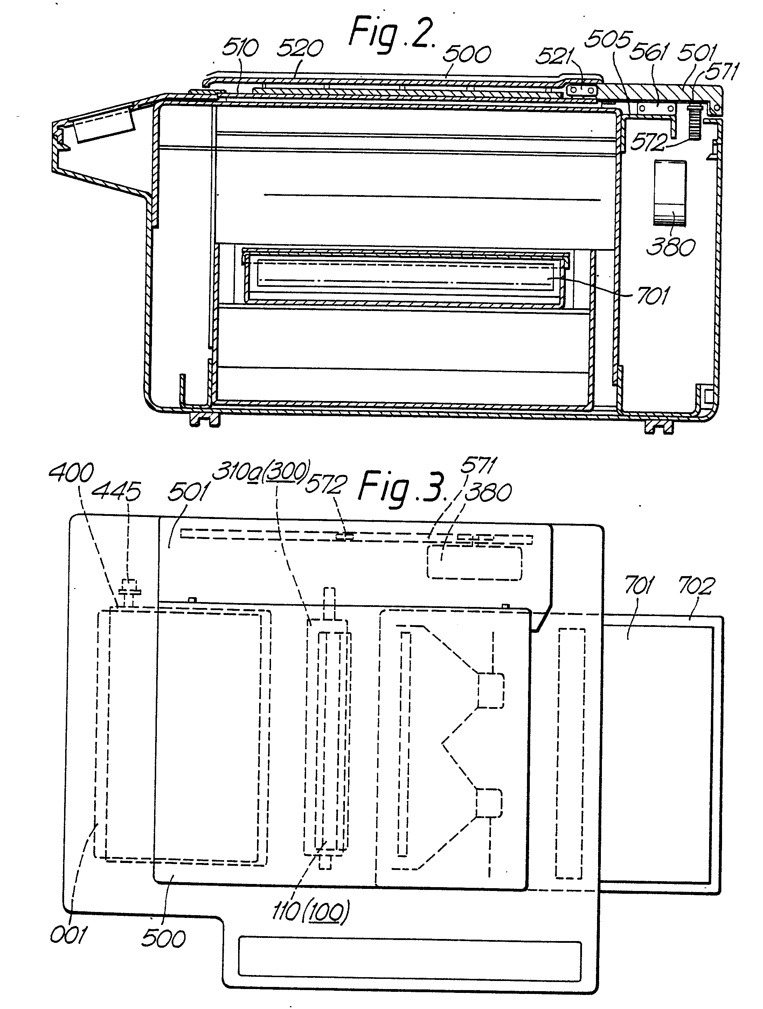

Figure 1 is a front sectional view showing a schematic structure of an image forming apparatus according to one embodiment of the present invention, Figure 2 is a sectional side view of the image forming apparatus of Figure 1, and Figure 3 is a top plan view of the image forming apparatus of Figure 1.

A non-exposed photosensitive medium 010 stored in a cassette 001 is discharged therefrom and moved at the same speed as a script table 500 which is moved right as seen in Figure 1, while a script 11 placed on the script table 500 is lit up by a lighting means 200 having a light source 3a, a filter 3d which reflects or absorbs heat rays from the light source 3a, and cooling fans 12, 12a. An image of the script 11 is formed on an exposure table 130 by an optical system 100. An image can be formed on the optical system 100 by using a self focussing lens array such as the SELFOC Lens Array made by Nippon Sheet Glass Co. Ltd. An image can therefore be formed on the photosensitive medium 010 by moving the latter at the same speed as that at which the script 11 is moved over the script table 500. For this purpose, the photosensitive medium 010 is exposed to light on the exposure table 130 which constitutes an exposure means so that a latent image of the script is formed on the photosensitive medium 010. A receiver sheet 701 stored in a receiver sheet cassette 702 is fed by a pick-up roller 650 and delivered into a pressure developer mechanism 300. The latent image is superposed on the receiver sheet 701 and both are pressed by the pressure developer mechanism 300, whereby microcapsules (not shown) on the photosensitive medium 010 are broken over a region corresponding to the latent image. Thus, material flowing from the broken microcapsules is transferred onto the receiver sheet 701. The photosensitive medium 010, which is pressed against a top pressure roller 310a by a pressing contact roller 630, is transported by the drive force of the pressing contact roller 630 and is taken up by a storage shaft 031.

The receiver sheet 701 is fed into a thermal treatment means 400, wherein a developing reaction is promoted and is given a gloss finish by heat. When a complete image has been formed on the receiver sheet 701, it is discharged from the apparatus.

In the above structure, there is no need to employ chemicals or complicated devices. Further, the apparatus is light, small and easy to handle. Moreover, it enables an image of good colour tone, resolution, and appearance to be produced.

As shown in Figure 2, a script is placed on a glass plate 510 and is pressed evenly by a lid 520. The lid 520 is supported by a movable table 501 through a hinge 521, and the glass plate 510 is also secured to the movable table 501. The movable table 501 moves on a side rail 561 secured to a frame 505. Power is transmitted to a rack 571 secured to a lower side of the movable table 501 through a gear or other connection, 572, such as a gear train or belt, to move the script table 500.

Photosensitive medium container

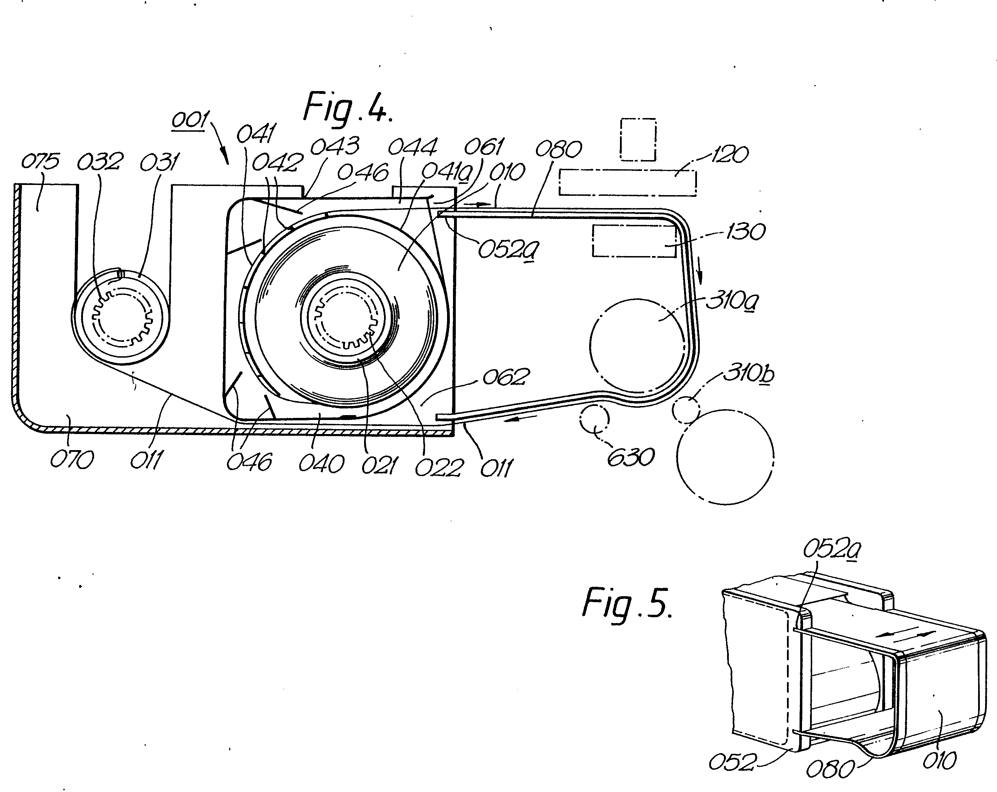

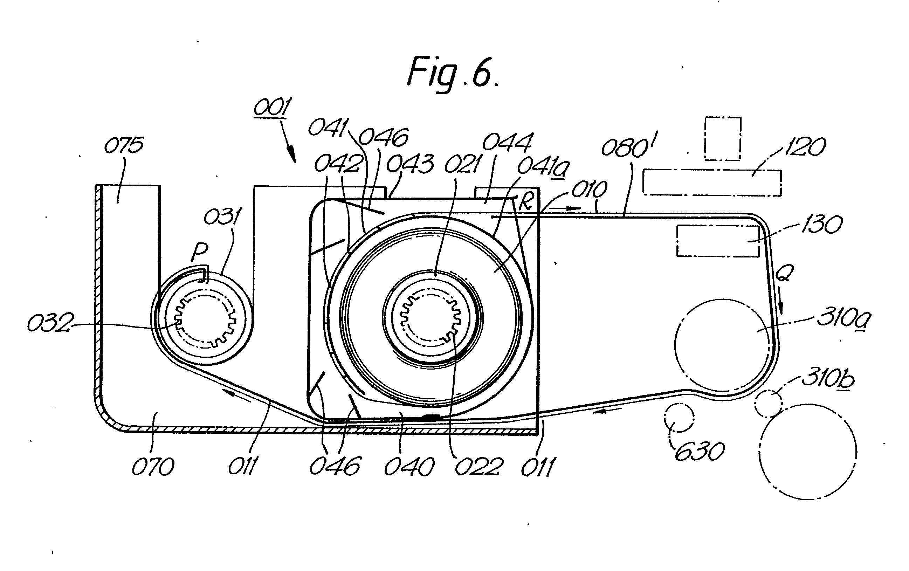

The cassette 001, which is a photosensitive medium container for storing the photosensitive medium 010, is described with reference to Figures 1 and 4-6. Figures 4 and 6 are schematic sectional views of the cassette, and Figure 5 is a partially cut-away perspective view of the cassette.

The cassette 001 is comprised of a cartridge 040, for storing non-exposed photosensitive medium 010, and an adjacent cassette body 070 for storing used photosensitive medium 010.

The cartridge 040 for storing the non-exposed photosensitive medium 010 has the following construction. A photosensitive medium guide 041 is moulded from a material or materials having light excluding properties or light absorbing properties, such as a black series synthetic resin plate, a black-painted metal plate, or a black hard paper. As shown in Figure 4, the photosensitive medium guide 041 is constituted by a substantially cylindrical portion 041a positioned in the interior of the guide 041 and an armour part 043. On the inner surface of armour part 043, blades or "dousers" 046 which are covered with black flock, for instance, or are coated black, are provided to absorb the light and are disposed at a distance from the photosensitive medium 010 so as not to contact the latter.

The armour part 043 is also formed on its inner surface with means for absorbing the light. The cylindrical portion 041a is moulded from black resin, and on a surface of the cylindrical portion 041a in direct contact with the rear surface of the photosensitive medium 010, there are formed several convex threads 042 to prevent adhesion between the photosensitive medium 010 and the cylindrical portion 041a.

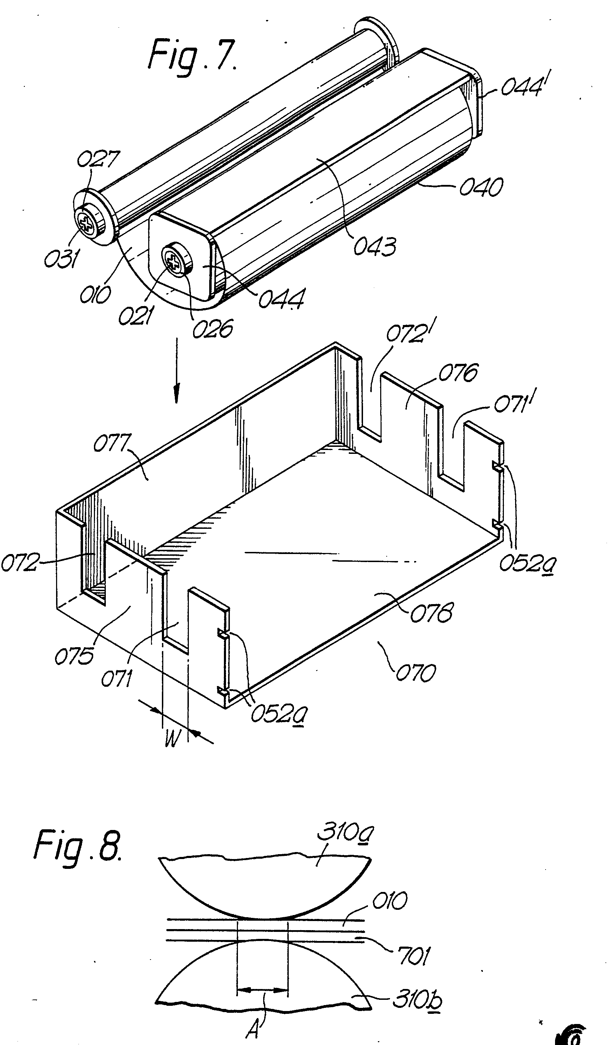

Inside the photosensitive medium guide 041 there is mounted a supply shaft 021 around which the photosensitive medium 010 is wound. The supply shaft 021 has a bearing part 021a at each of its opposite ends. Each of the bearing parts 021a is formed with internal teeth 022. The internal teeth 022 are adapted to mesh with external teeth of a rewinding or external driving shaft (designated at 610 in Figure 1) for applying tension to the photosensitive medium 010 when it is fed in the forward direction and also for rewinding the photosensitive medium 010 by the rotational force of the rewinding shaft 610 when the photosensitive medium 010 needs to be rewound. Reference numerals 044, 044' (Figure 7) denote side plates which have holes for supporting the supply shaft 021. The photosensitive medium guide 041 is adhered to or is fitted into the side plates 044, 044' without a space.

Reference is now made to Figure 7, wherein reference numeral 070 denotes a cassette body in which the cartridge 040 and the storage shaft 031 are installed. The cassette body 070 is formed of a thin plate of metal or synthetic resin and has openings on the top and front sides. On both the left and right sides 075, 076 of the cassette body 070, there are formed grooves 071, 071', 072, 072' respectively for holding the supply shaft 021 and the storage shaft 031. The supply shaft 021 and the storage shaft 031 have on their end faces internal teeth or cross slits fitting the ends of the rewinding shaft (indicated at 610 in Figure 1) and a take-up shaft (indicated at 620 in Figure 1) so that the torque of the rewinding shaft 610 and of the take-up shaft 620 is transmitted to the supply shaft 021 and the storage shaft 031. On the ends of the supply shaft 021 and the storage shaft 031 there are mounted bearing rings 026 and 027 which have outer peripheries which may be tightly received within the width W of the grooves 071, 072, respectively, and inner walls for rotatably supporting the supply shaft 021 and the storage shaft 031.

The cassette body 070 may be formed from black resin, black-painted metal plate, and so on. In this embodiment, the photosensitive medium 010 may be drawn to some extent from the cartridge 040, which stores it under lightproof conditions, and wound around the storage shaft 031. Then, the bearing rings 026 and 027 which are mounted on the supply shaft 021 and the storage shaft 031 respectively are pressed into the grooves 071 and 072 in the direction of the arrow shown in Figure 7. The cassette 001 is thus completed. Non-used photosensitive medium 010 is discharged through a discharge port 061 (Figure 4), while used photosensitive medium 011 is stored after passing through a storage port 062 (Figure 4).

Side plates 075, 076 shown in Figure 7 have slots 052a into which a U-shaped member 080 (Figure 4) is detachably fitted. The configuration of the shaped member 080 closely resembles that of the path of the photosensitive medium 010 through the apparatus, and the size of the shaped member 080 is such that it may be removably inserted into spaces between a filter 120 and the exposure table 130, between a top pressure roller 310a and an intermediate pressure roller 310b, and between the top pressure roller 310a and a pressing contact roller 630. A roll of non-used photosensitive medium 010 is stored on the supply shaft 021 provided inside the cassette 001, while the end of the photosensitive medium 010 passes through an inlet 062 (Fig.4) and an outlet 061 of the cassette 001 and is attached to the storage shaft 031, the bare part of the photosensitive medium 010 coming out of the cassette 001, i.e. the rear surface thereof which is opposite to a microcapsule-provided surface thereof, is mounted on the outer surface of the shaped member 080.

Regarding the material of the shaped member 080, thick paper or synthetic resin is suitable because they are unlikely to damage the photosensitive medium 010. A preferable thickness of the shaped member 080 is 0.1 to 0.2 mm. When the thickness is less than 0.1mm, the shaped member 080 may not be sufficiently rigid and hence may easily get out of shape. In contrast, when the thickness is more than 0.2mm, the aforementioned spaces have to be bigger, which is a disadvantage.

The way in which the cassette 001 and photosensitive medium 010 are set up in operation will now be described with reference to Figures 1 and 4. At first, the inner periphery of the shaped member 080 is mounted on the outer periphery of the exposure table 130 and of the top pressure roller 310a , while the cassette 001 is inserted into the apparatus in such a way that the outer periphery of the cassette 001 is fitted into the inner periphery of the frame of the apparatus. Then, the cassette 001 and the shaped member 080 are pressed inwardly at the same time parallel to the insert direction. When the cassette 001 is replaced with a new one, a space is provided between the top pressure roller 310a and the intermediate pressure roller 310b by another mechanism described later on. Therefore, the photosensitive medium 010 which is guided by the shaped member 080 is easily inserted into this space. After setting the cassette 001 in position, the shaped member 080 is taken out and any slack in the photosensitive medium 010 is adjusted so that the start condition is obtained. When the photosensitive medium 010 is used up, the supply shaft 021 has no photosensitive medium thereon, while the used photosensitive medium 010 is all taken up by the storage shaft 031. In this case, the cassette 001 is removed and is replaced with a new one.

Another embodiment is described with reference to Figure 6 which is a main sectional view showing the start condition of cassette 001 and the photosensitive medium 010. In Figure 6, reference numeral 010 denotes the photosensitive medium, 080' a shaped member, 001 a cassette, 021 a supply shaft, and 031 a storage shaft. In this embodiment, the shaped member 080' is made of woodfree paper with a relatively high rigidity and a thickness of 0.1mm. Further, the shaped member 080' is adhered to the rear surface of the photosensitive medium 010 from the top end thereof over a predetermined length (from P to R in Figure 6) allowing the bare part of the photosensitive medium 010 coming out of the cassette 001 to have the configuration shown in Figure 6. Accordingly, the photosensitive medium 010 is easily given the shape of the shaped member 080'.

The left hand end of the shaped member 080' is secured to the storage shaft 031 and is wound up around the storage shaft 031 when the latter rotates. Thus the shaped member 080' is not attached to the cassette 001.

As indicated above, the shaped member 080' may be made of a fine paper having a thickness of 0.1mm, and this paper may be adhered to the portions R-Q and P of the photosensitive medium 010. Therefore, since the photosensitive medium 010 is maintained by the said paper in the shape shown in Figure 6, the cassette 001 may be easily set in place in the apparatus. Furthermore, in the subsequent printing operation, the shaped member 080' is wound up by the storage shaft 031 while maintaining its shape, so that the shaped member 080', unlike the shaped member 080, need not be removed.

The photosensitive medium 010 stored in the cassette 001 has the following features and hence, requires careful attention in handling. The photosensitive medium 010 is coated throughout its outer surface with microcapsules (not shown) containing optical hardening matter and a dye precursor. Since non-exposed microcapsules are not hardened, if the surface of the photosensitive medium 010 is rubbed or pressed, the microcapsules are broken and the dye precursors flow out. Such a broken capsule part causes deterioration of the image formed on the receiver sheet 701. In order to prevent such damage, the outer surface of the photosensitive medium 010 should not be subjected to any mechanical contact until the end of the pressure developing step.

The cassette 001 employed has the aforementioned construction and all the guides of the photosensitive medium 010 are provided in contact with the rear surface of the photosensitive medium 010 so as not to contact the front or outer surface thereof. Accordingly, the photosensitive medium 010 is fed in such a way that its quality is maintained.

The cassette 001, which forms a photosensitive medium container, is lightproof and the photosensitive medium is supported therein on the reverse side to the side having the photosensitive layer, i.e. the layer of microcapsules. Further, the container is composed of a cartridge 040 which is mounted on the supply shaft 021 around which the photosensitive medium 010 is wound, and there is a cassette case body 070 for holding the cartridge 040. The effect is as follows:

a) The non-exposed photosensitive medium 010 is not subjected to any mechanical contact on the surface formed with the photosensitive layer, and is protected from being touched by hand by virtue of the cassette case body 070. As a result, a good quality image can be obtained without damage and unevenness in density.

b) When the cassette 001 is assembled, the non-exposed photosensitive medium 010 is stored in a lightproof cartridge 040, while the cartridge 040 itself can easily be handled in the light. Therefore, it is easy to wind the photosensitive medium 010 around the storage shaft 031 in the cartridge 040 and then to set the latter in the cassette case body 070.

c) The cassette 001 is thus composed of the photosensitive medium 010, the supply shaft 021 and the storage shaft 031 on which the photosensitive medium 010 is wound. Accordingly, the setting operation for setting the photosensitive medium 010 in position in the apparatus is easy and any trouble caused by a mistake in the setting operation is prevented beforehand. Additionally, since used photosensitive medium 010 is wound around the storage shaft 031, it need not be disposed of.

Moreover, the shaped member 080 is attached to the side wall of the photosensitive medium cassette 001 and shaped so as to allow the photosensitive medium 010 to be shaped as shown when the photosensitive medium 010 is mounted on the outer periphery of the shaped member 080. As a result, it is possible to load the photosensitive medium 010 into the apparatus without touching the photosensitive medium 010 which is extremely thin (approximately 25 μmm), weak and relatively wide. Thus, the loading and disposal of the photosensitive medium 010 are greatly facilitated, and troubles such as paper wrinkling and paper jamming are substantially prevented. The cassette 001 which contains the storage shaft 031 as well as the supply shaft 021, allows the remaining part of the apparatus to be free of a storage shaft and hence the transportation system is simplified.

## Pressure developer means

Referring to Figure 1, the photosensitive medium 010, on which an image has been exposed by an optical exposing system 100, is closely attached to the receiver sheet 701 and is pressed and developed by the pressure developer means 300 which is described in detail later on. That is to say, the photosensitive medium 010 has rupturable microcapsules (not shown) which contain material part of which is adapted to form an image and part of which, on exposure to light, alters the hardness or softness of the microcapsules. The optical exposing system 100 exposes the photosensitive medium 010, and hence the microcapsules thereon, to a predetermined light pattern so that selected microcapsules will subsequently be ruptured by the pressure developer means 300 so as to produce an image on the receiver sheet 701. It is important that the pressure developer means 300 shall be small in size and weight so as to form part of a small image forming apparatus. It is also important that the microcapsules on the photosensitive medium 010 should be subjected to uniform pressure.

The pressure required for developing the photosensitive medium 010 and the receiver sheet 701 in the case of the apparatus of Figure 1 is substantially 1000 kg/cm$^2$. The above pressure may be generated by a small apparatus and hence one of rollers directly pressing the photosensitive medium 010 and the receiver sheet 701 may have a smaller diameter than the other. Thus, at least one of the rollers may have a diameter of 4 to 10mm. As a result, the contact width A (nip width) shown in Figure 8 is decreased so that a high pressure can be obtained by a relatively low load. In addition, a big-diameter roller supporting the small-diameter roller at the back may be so disposed as to prevent deflection of the small-diameter roller, thereby generating a uniform pressure distribution. The small-diameter pressure roller may be moved into or out of contact with the opposite roller by a cam mechanism when the receiver sheet 701 is inserted between the pressure rollers. In addition to the opening and closing movement of the pressure roller at each sheet insertion, the side wall of a frame supporting the rollers may be opened when the photosensitive medium 010 is shaped into a closed loop to facilitate handling or is replaced.

A pressure developer means according to one embodiment of the present invention, will be described in detail, other embodiments thereof, which embody a method of obtaining a uniform pressure distribution, an opening-and-closing mechanism, and so on, also being referred to.

The construction of the pressure rollers, pressure cam mechanism, and frame will first be described below.

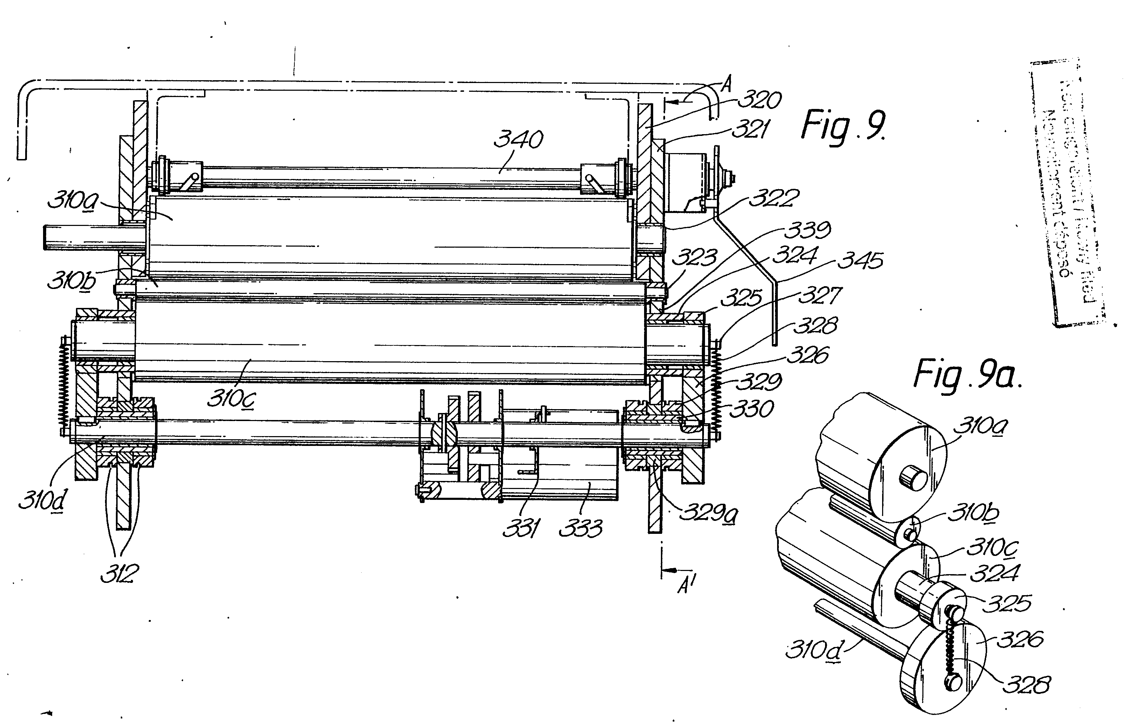

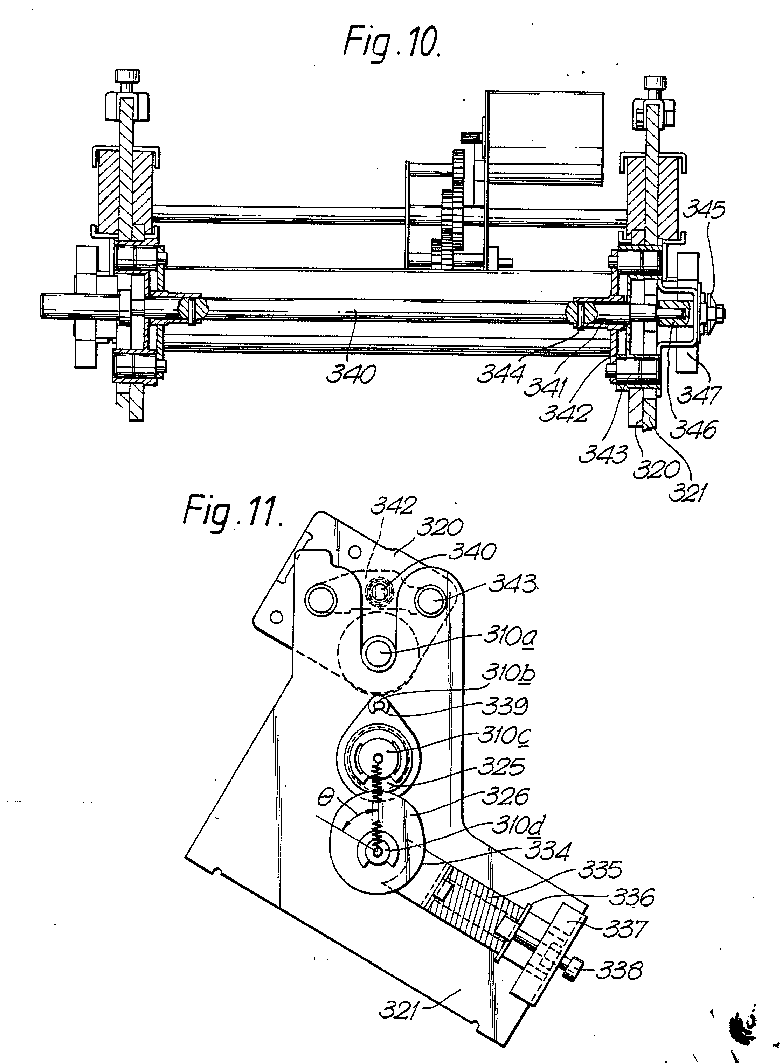

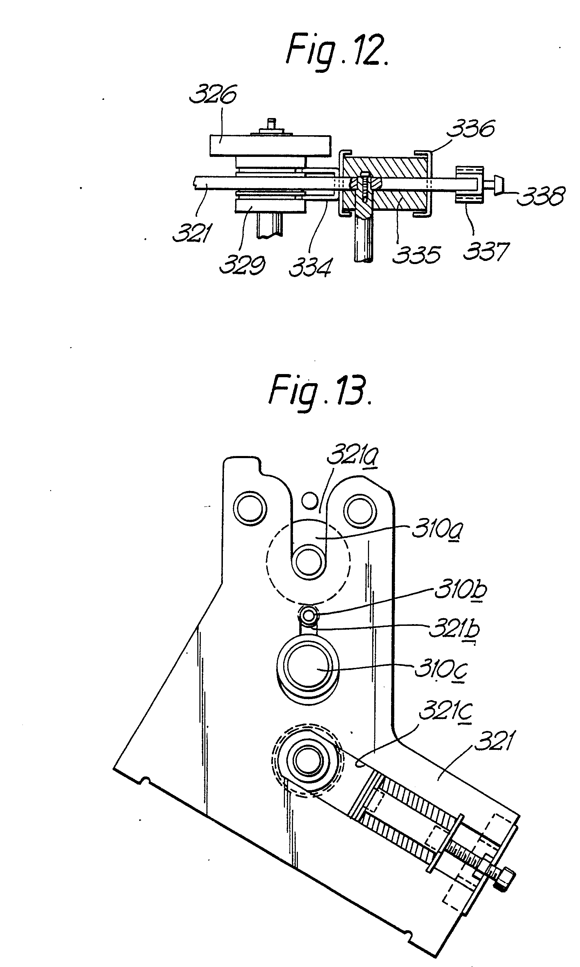

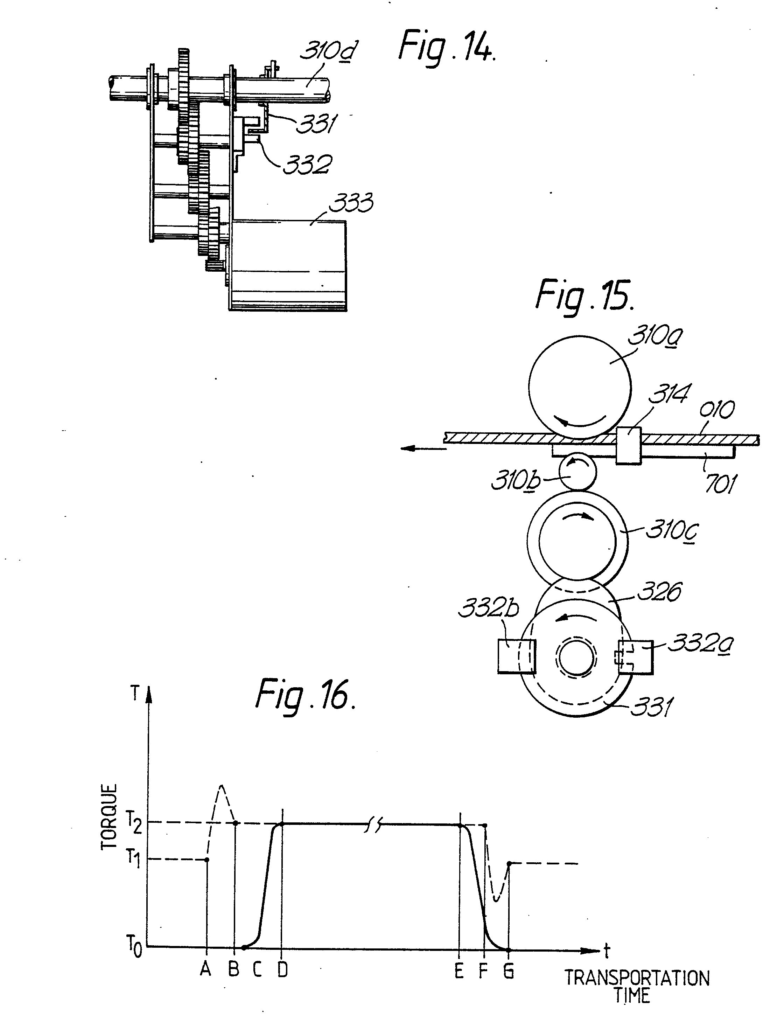

Referring to Figures 9-14, Figure 9 is a sectional view of the pressure part of the pressure developer means according to one embodiment of the present invention, Figure 9a is a broken away perspective view of part of the structure shown in Figure 9, Figure 10 is a plan view of the structure shown in Figure 9, Figure 11 is a side view of the structure shown in Figure 9, Figure 1s is a bottom plan view of the structure shown in Figure 11, Figure 13 is a sectional view taken along lines A-A' in Figure 9, and Figure 14 is a bottom plan view of the structure shown in Figure 9. The embodiment shown in Figures 9-14 is constructed so that an opening mechanism on the side of the frame supporting the pressure rollers is included in a so-called clamshell mechanism for vertically dividing the apparatus frame from the receiver sheet passage.

In the construction of Figures 9-14 two coupling support plates 320 are secured to top frames 315 shown in Figure 1. A top pressure roller 310a is rotatably engaged with the coupling support plates 320 through bearings 322. A shaft 340 is rotatably mounted in the coupling support plates 320. A collar 341 formed with a helical groove extending through 180° is slidably mounted on each end of the shaft 340 and the helical groove is engaged with a pin 344 fixed on shaft 340. A plate 342 is attached to each collar 341. On each of the opposite ends of each plate 342 there is fixed a slide pin 343 which is engageable with the respective coupling support plate 320 and with the respective support plate 321. A meshing pin 346 is fitted on the right hand end of the shaft 340 and is locked by a fixing ring 347. A lever 345 is mounted on the end of the meshing pin 346. The support plates 321 are secured to the inner surfaces located at both ends in the width direction of the bottom frame shown in Figure 1. An intermediate pressure roller 310b and a bottom-or back-up pressure rollers 310c are rotatably mounted in the support plates 321 by way of shafts 323 and 324, respectively. A pressure application shaft 310d is rotatably mounted in the support plates 321 by way of shaft bearings 330 and sleeves 329a. The top pressure roller 310a is rotatably mounted in the support plates 321 except when the top frame is open, the slide pins 343 normally being engaged with the support plates 321 so as to be coupled to the coupling support plates 320. As shown in Figure 13, each support plate 321 has at its upper portion a groove 321a in which the top pressure roller 310a can be slidably engaged, the groove 321a having a curvature whose radius corresponds to the distance between a rotational shaft 317 shown in Figure 1 and the centre of the groove 321a. Each support plate 321 is also formed with a deformed long hole 321b which allows for the vertical movement of the intermediate and bottom pressure rollers 310b and 310c. Each support plate 321 also has a long hole 321c in which a sleeve 329a, an application sleeve 329 and an application spring 335 are movable.

When a top frame 15 (Figure 1) is opened upwardly, a lever 345 can be turned clockwise so that the collars 341, plates 342 and slide pins 343 are slid inwards so as to be disengaged from the support plates 321. Then, the top frame 15 is turned until its foot 15a (Figure 1) abuts on the bottom of a bottom frame 16 and is made stationary. At this time, a spring 18 shown in Figure 1 serves to push up the top frame 15 which has turned upwardly on the pivot provided by a rotational shaft 317 so that the top frame 15 is kept open. The turning of the lever 345 is accompanied by the rotation of the pin 346 and the shaft 340 so that the collars 341 in engagement with the shaft 340 are moved inwardly of the coupling support plates 320 by the pins 344 in engagement with the grooves of the collars 341. Thus, the slide pins 343, which are attached to the collars 341 through the plates 342, are disengaged from the support plates 321. From the preceding operation, the top pressure roller 310a, which is one roller in contact with the pressure-receiving material comprised of photosensitive medium 010 and receiver sheet 701, is openable in unison with the top frame 15 through the coupling support plates 320. At the pressure developing time, the coupling support plates 320 and the support plates 321 are coupled to each other through the slide pins 343, whereby the top pressure roller 310a is capable of applying pressure to the pressure-receiving material 010, 701 in cooperation with intermediate pressure roller 310b which is the other roller in contact with the pressure-receiving material 010, 701.

A mechanism for moving the intermediate pressure roller 310b towards and away from the top pressure roller 310a is next described.

Immediately after the top end of the receiver sheet 701 which has been superposed on the exposed photosensitive medium 010 is inserted between the top and intermediate pressure rollers 310a and 310b, this position is detected. In response to the detection, a motor 333 (Figure 14) is actuated so that the pressure application shaft 310d begins to be revolved via a reduction gear train. The rotation of the pressure application shaft 310d causes turning of a pressure cam 326 (Figure 9) mounted on the pressure application shaft 310d. The pressure cam 326 pushes the bottom pressure roller 310c upwardly by way of a cam follower 325 which is in contact with the pressure cam 326. Then the intermediate pressure roller 310b mounted on the bottom pressure roller 310c is moved up towards the top pressure roller 310 a. As a result, the photosensitive medium 010 and the receiver sheet 701 are pressed between the top and intermediate pressure rollers 310 a and 310b, whereby an image starts to be formed on the receiver sheet 701. Subsequently, when the pressure cam 326 reaches the top dead centre, this position is detected by a detector 332 (Figure 14) through a cam switch 331, and the motor 333 is stopped. Accordingly, the pressure developing state is maintained so that the image is kept formed.

The feed speed under pressure is controlled by using the output of an encoder attached to the drive motor 333. A DC servo motor, a step motor, an AC motor or the like may be used for the drive motor 333.

When a detector 314 (Figure 15) detects the bottom end of the receiver sheet 701, the motor 333 is actuated again and the pressure application shaft 310d is rotated. The rotation of the application shaft 310d is transmitted to the intermediate and bottom pressure rollers 310b and 310c through the pressure cam 326 and the cam follower 325 so as to move them downwardly out of contact with the pressure-receiving material comprised of the photosensitive medium 010 and the receiver sheet 701. Thus, the pressure is removed from the pressed materials. When the detector 332 (Fig.14), through the cam switch 331, detects the position where the pressure cam 326 reaches the bottom dead centre, the motor 333 is stopped and the application shaft 310d is also stopped. As a result, the intermediate and bottom pressure rollers 310 b and 310c return to the start position. The transferability-controlled transfer matter on the exposed photosensitive medium 010 is pressed for development on the receiver sheet 701 only in an image formation area. Other areas of the receiver sheet 701 are not subjected to any pressure because they are out of contact with the photosensitive medium 010 by reason of the fact that the intermediate and bottom pressure rollers 310b and 310c are moved down.

The intermediate pressure roller 310b and the bottom pressure roller 310c are coupled to each other through coupling plates 339 (Figure 9) for their unitary up and down movement.

The bottom pressure roller 310c and the pressure application shaft 310 d are provided with spring holders 327 (Figure 9) on each of their respective ends, springs 328 being engaged with the spring holders 327. Accordingly, the cam follower 325 and the pressure cam 326 are always in contact with each other by virtue of the springs 328. Inwardly of the pressure cam 326 adjacent to the end portion of pressure application shaft 310d , the application sleeve 329, which has grooves 312 therein, with a sleeve 329a - (Figure 9) interposed therebetween, is engaged with a bearing 330. The grooves 312 of the application sleeve 329 are formed adjacent a surface of an application spring receiver 334 (Figure 12). A cylindrical projecting portion formed on the opposite surface of the application spring receiver 334 is fitted into an application spring 335 to guide the inside diameter thereof. The application spring 335 constitutes a pressure source and abuts on the brim portion of the application spring receiver 334. The other end of the application spring 335 abuts on the brim portion of an application spring restrainer 336. A cylindrical projection portion formed on the application spring restrainer 336 is fitted into the inside diameter of the application spring 335. The application spring restrainer 336 is engaged with a pressure adjustment screw 338 for adjusting the pressure of the application spring 335, through a plate 337 engagingly attached to a support plate 321.

In the above structure, the pressure generated by the application spring 335 is transmitted to the pressure application shaft 310d through the application spring receiver 334 and the sleeve 329. Then, the pressure is transmitted from the pressure cam 326 mounted on the application shaft 310d to the bottom pressure roller 310c through the cam follower 325. Simultaneously, the pressure is also transmitted to the intermediate pressure roller 310b mounted on the bottom pressure roller 310c, with the result that the intermediate pressure roller 310b applies the pressure to the photosensitive medium 010 and the receiver sheet 701 against the top pressure roller 310a.

The detector 314 (Figure 15) is a photocoupler wherein a light emitting element, such as a light emitting diode, and a light-passive element, such as a phototransistor, are incorporated unitarily. The detector 314 detects the difference in reflectance between the surface of the photosensitive medium 010 and the surface of the receiver sheet 701. When the top end of the receiver sheet 701 passes the detector 314, since the receiver sheet 701 is of a higher reflectance than the photosensitive medium 010, the light incident upon the light-passive element is increased, resulting in an increase in the current flowing through the light-passive element. This change is detected by a control circuit, not shown, whereby the motor 333 is rendered conductive so that the intermediate pressure roller 310b is moved upwardly. The detection of the bottom end of the receiver sheet 701 is based on a similar operation principle and hence is omitted.

Figure 16 shows the relationship between the transportation time $t$, which relates to the positional relationship between the actuation and stopping of the motor 333 for rotating the pressure application shaft 310d, and the torque T of the pressure roller 310a in the case both of the present pressure developer 300 and the prior art pressure developer. In the graph of Figure 16, the characteristic of the present pressure developer 300 is shown by a solid line, and that of the prior art is shown by a dotted line. The following is the positional relationship of the actuation and stopping of the motor 333 for feeding the receiver sheet 701 and for rotating the pressure application shaft 310d at respective points of the transportation time $t$ on the abscissa.

Point $T_0$ ---The top end of the receiver sheet 701 reaches the detector 314.
Point A ---The top end of the receiver sheet 701 starts to enter the bite or nip of the pressure rollers.
Point B ---The bite of the top end is completed.
Point C ---The motor 333 starts to be driven.
Point D ---The motor 333 is stopped. (The pressure cam 326 reaches the top dead centre, and a notch of the cam switch 331 reaches a detector 332a (Figure 15).)
Point E ---The bottom end reaches the detector 314. The motor 333 is actuated.
Point F ---The bottom end starts to be fed out from the pressure rollers.
Point G ---The bottom end is completely fed out. The motor 333 is stopped. (The pressure cam 326 reaches the bottom dead centre, and the notch of the cam switch 331 reaches a detector 332b.) The motor 380 is driven after a time interval C - $T_0$ shown in Figure 16 so that the receiver sheet 701 is pressed after it reaches the pressure rollers.

Pressure is applied to only the image formation area of the receiver sheet 701, the other areas being subjected to no pressure because a space is provided between the pressure rollers. Therefore, the pressure rollers are not rotated so that no torque is generated until Point C. In the prior art, however, the load is always imposed and hence, the pressure rollers are rotated so that torque T1 is generated until Point A. When the top end of the receiver sheet 701 passes by the pressure rollers by reason of the operation of the pressure means shown in Figures 9 and 10, namely, the motor 333, the application shaft 310d , the pressure cam 326 and so on, and then reaches Point C, the load begins to be applied. Accordingly, the sharp torque change occurring at the bite time in Points A-B as seen in the prior art is not generated in the construction described above and the torque slowly rises from Point C along the configuration of the pressure cam until Torque T2 at the pressure developing time. Then at Point D, when the pressure cam 326 reaches the top dead centre, the motor 333 is stopped and the pressure developing state is retained. At Point E, the motor 333 is actuated and the load starts to be removed. At point F, the bottom end of the receiver sheet 701 starts to be fed out from the pressure rollers. At Point G, the bottom end is released and the pressure cam 326 reaches the bottom dead centre. The motor 333 is therefore stopped and the load is removed. As a result, a space is provided between the pressure rollers again and the torque returns to the initial torque $T_o$ . At this time, the sudden torque change occurring at the sheet-feeding-out time in Points E-F as seen in the prior art is not generated in the construction described above.

As regards the method of determining the timings for the removal of the load imposed on the pressure rollers, there is another method in which the size of the receiver sheet is detected beforehand in a receiver sheet storing tray and, on the basis of this information, the length of the application of pressure is calculated. The manner of detecting the size of a receiver sheet is described in detail later on.

As described above, the pressure developer has detector means for detecting the top and bottom ends of the receiver sheet 701, and a pressure means in which at least one pressure roller in contact with the pressure-receiving material 010, 701 is moved up and down, whereby the photosensitive medium 010 and the receiver sheet 701 are pressed together immediately after the top end of the receiver sheet 701 has passed through the pressure rollers, and the pressure is removed when the bottom end has passed through the pressure rollers so as to maintain the space between the pressure rollers. Accordingly, it is possible to prevent the surface of the pressure roller from being smeared by the microcapsules which have not been used for image formation but which are broken by the pressure.

In addition, pressure is not applied to any area except for the image formation area on the top and bottom ends of the pressed materials so that the microcapsules on such non-pressed areas of the photosensitive medium 010 are not broken. Accordingly, it is easy to separate the receiver sheet 701 from the photosensitive medium 010 after the pressure development. Further, it is possible to prevent a sudden torque change of the pressure rollers at the time that the receiver sheet 701 enters and leaves the nip of the rollers, with the result that the maximum torque is decreased and hence, the load imposed on the drive motor is reduced. Furthermore, when the receiver sheet 701 is fed out from the pressure rollers, there is neither noise nor shock because the pressure rollers are prevented from impact, whereby the photosensitive medium 010 is not damaged. Additionally, it is thus possible to provide a pressure developer which has a high stability in transporting the pressure-receiving material 010, 701 without any substantial wrinkling, displacement, or jamming thereof.

The pressure rollers in contact with the pressure-receiving material composed of the exposed photosensitive medium 010 and the receiver sheet 701 are divided into two with the frames 15,16 pivotally engaged, whereby the transportation system of the photosensitive medium 010 is incorporated in one frame 15,while the feed system of the receiver sheet 701 is incorporated in the other frame16. Besides, one frame is rotated into the openable position. Accordingly, it is easy to deal with wrinkling, displacements, and jamming of the sheet caused by malfunction of the feed system. In addition, mechanical troubles and maintenance are easily provided for.

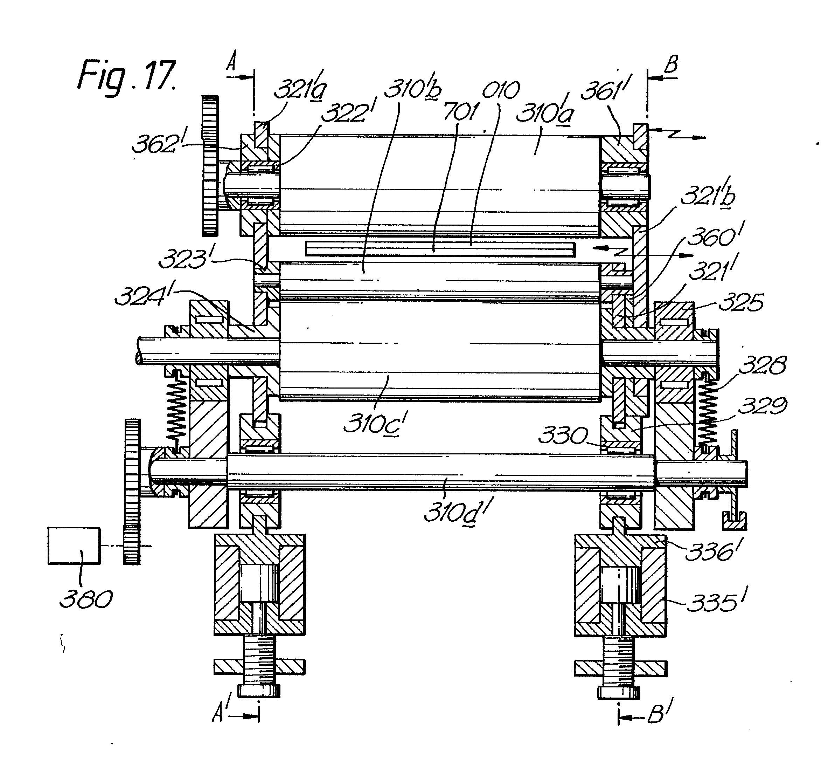

Another embodiment of the mechanism for opening the side frame supporting the pressure rollers will now be described with reference to Figures 17-20. In this embodiment, one of two frames supporting the pressure rollers at both ends supports the top, intermediate, and bottom pressure rollers as a whole, while the other is divided into top and bottom frames which are coupled to each other at the operation time.

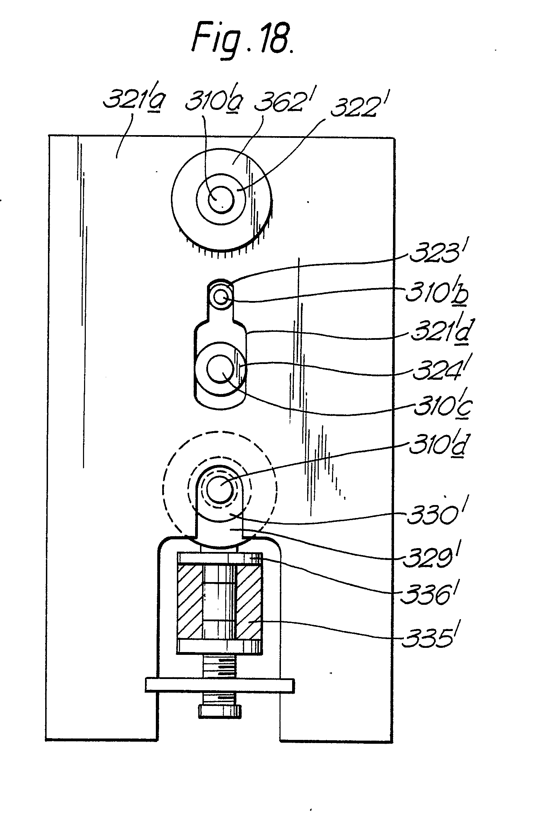

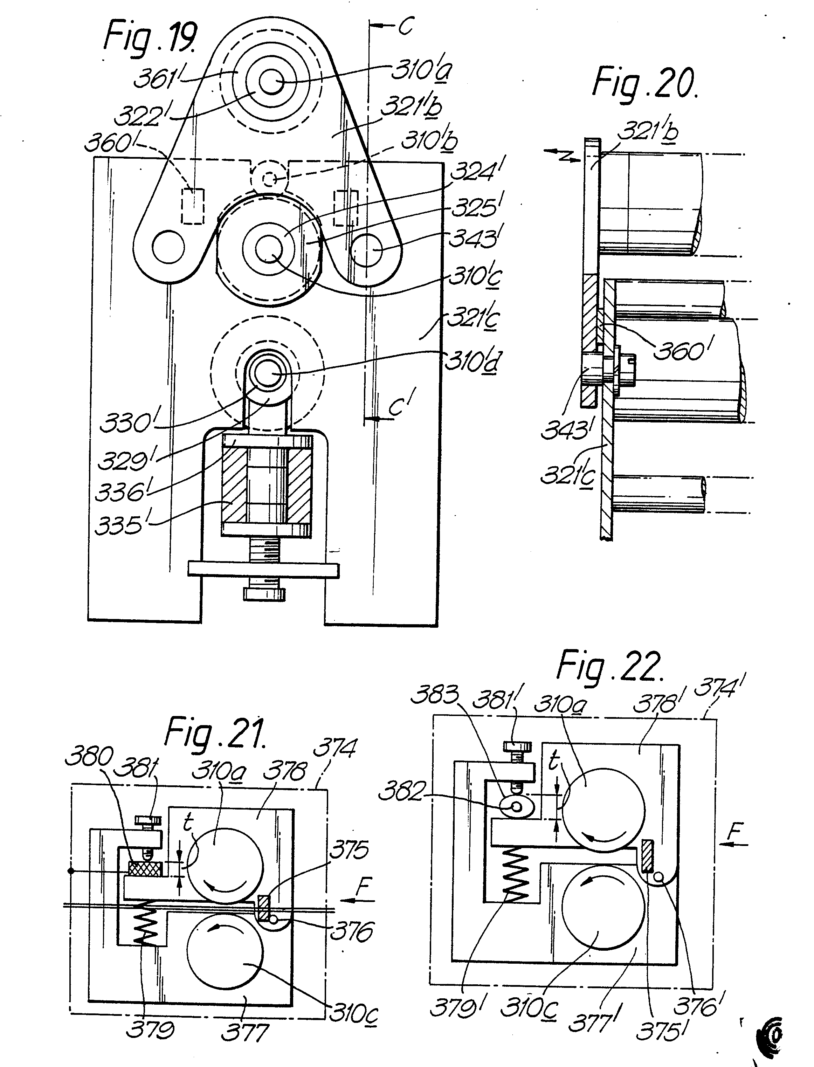

Figure 17 is a sectional view of the pressure part of the pressure developer according to this embodiment, Figure 18 is a sectional view taken along the line A-A' of Figure 17, Figure 19 is a sectional view taken along the line B-B' of Figure 17, and Figure 20 is a sectional view taken along the line C-C' of Figure 19.

In Figures 17-20, one end of the top pressure roller 310a'is rotatably fitted into a groove on the upper portion of a support plate 321'a shown in Figure 17 through a bearing 322' and a fixing ring 362'. The other end of the top pressure roller 310a' is rotatably and detachably fitted into a groove on the upper portion of a coupling support plate 321'bshown in Figure 17 through a bearing 322' (Figure 19) and a fixing ring 361'. An intermediate pressure roller 310'b is disposed at a lower position than the top pressure roller 310a', respective ends of the top and intermediate pressure rollers 310a', 310b being rotatably and vertically movably engaged with support plates 321'a and 321'b , respectively, through bearings 323'. A bottom pressure roller 310'c is disposed at a lower position than the intermediate pressure roller 310'b, respective ends of bottom pressure roller 310'c being rotatably and vertically movably engaged with support plate

321'a and support plate 321'c , respectively, through bearings 324'. Coupling support plate 321'b holds in its upper position a fixing ring 361' fitted on the top pressure roller 310'a, and is fitted in its lower position on two guide pins 343' (Figure 19) secured to the support plate 321'c to be detachably made stationary thereon by a magnet 360'. The coupling support plate 321'b also has a semi-circular notch portion so as to avoid a cam follower 325' mounted on the bottom pressure roller 310'c for easy attachment and detachment. In the above construction the top pressure roller 310'a in the pressure development means is supported at both ends by the support plate 321'a and coupling support plate 321'b for supporting the load. When the photosensitive medium 010 in the closed-loop is inserted into or removed from the apparatus, the coupling support plate 321'b is taken off so that the top pressure roller 310'a is supported at only one end by the support plate 321'a. Thus the longitudinal side of the pressure roller 321'a is open and hence the photosensitive medium 010 can be easily inserted into or removed from the longitudinal side of the pressure roller. The intermediate pressure roller 310'b in contact with the pressure-receiving material is mounted on the bottom pressure roller 310'c to thereby follow the vertical movement of bottom pressure roller 310'c. When the longitudinal side of the pressure roller 310'a is open for allowing the insertion or removal of the photosensitive medium 010 as described above, the intermediate pressure roller 310'b is moved down to space it further from the top pressure roller 310'a so as to facilitate the insertion or removal of the photosensitive medium 010.

The mechanism other than the opening mechanism of the top and bottom frames is similar to the first embodiment and hence, the description is omitted here.

It is easily understood that this embodiment also has a similar effect to that of the aforementioned embodiment.

A further embodiment for applying a load on the pressure roller is next described. Reference is made to Figure 21 which shows the construction of the pressure developer according to this embodiment. In Figure 21, the receiver sheet 701 is attached to the photosensitive medium 010 and inserted in the direction of an arrow F into the space provided between pressure rollers 310a and 310c which space is larger than the thickness of the photosensitive medium 010 and receiver sheet 701. After a predetermined time has elapsed after the top end of the receiver sheet 701 has been detected by a detector, a predetermined voltage is applied to a piezo-electric actuator 333, thereby increasing the size $t$ of the piezo-electric actuator 333. As a result, a top frame 378 on which piezo-electric actuator 333 is fixed, and a bottom frame 377 are angularly moved around a fulcrum 376 so that the space provided between the pressure rollers 310a and 310c is reduced, whereby a predetermined pressure is applied to the photosensitive medium 010 and receiver sheet 701. Thus, an image is transferred to the receiver sheet 701. Subsequently, when the bottom end of the receiver sheet 701 reaches a detector 375 disposed on the inlet side of the pressure rollers 310a, 310c, the voltage application on the piezo-electric actuator 380 is removed, whereby the size $t$ of the piezo-electric actuator 380 is restored to the initial size. Accordingly, the space between pressure rollers 310a and 310c returns to the initial state by reason of the action of a pressure spring 379. The initial setting of this space is carried out by an adjustment screw 381.

Yet a further embodiment of the mechanism for applying a load on the pressure rollers is described hereinbelow. Reference is made to Figure 22 which is a structural view of this embodiment. In Figure 22, the size $t$ is changed from $a$ to $b$ at maximum by an elliptical cam 383 having the long axis a and the short axis $b$. The cam 383 is rotated around a rotational shaft 382, whereby pressure is applied to the pressure rollers 310a, 310c. Similarly to the embodiment shown in Figure 21, the position of the receiver sheet 701 is detected by a detector 375' and, on the basis of the detection, the output of the control circuit is controlled. The elliptical cam 383 is stationary at the centre of the rotational shaft 382 which is coupled to a motor through a gear train, not shown. The rotation of the motor is reduced in speed by the gear train. In response to the output of the control circuit, not shown, the motor is rotated so as to rotate the elliptical cam 383. Thus, the size $t$ is changed and the distance between the pressure rollers 310a, 310c is adjusted. Also in this embodiment, the control of the extent of the motor rotation allows the distance between the pressure rollers 310a, 310c to be set at a given value.

## The construction of the pressure rollers

The construction of respective pressure rollers is described in detail. The top, intermediate, and bottom pressure rollers 310 a, 310b, 310c have pressure developing parts with the diameters of $\phi$ 40mm, 5mm, and 40mm, respectively. The destruction of the microcapsules provided on the photosensitive medium 010 requires a certain load for a predetermined unit of area. A decrease in the diameter of the pressure part of at least one of the pressure rollers in contact with the pressure-receiving material 010, 701 reduces the contact area between the pressure rollers and the pressure-receiving material 010, 701 and hence also reduces the load on the pressure rollers. If a sheet of the size A4 (sheet width: 210mm) is pressed for development between two pressure rollers each having a diameter of ∅ 40mm as seen in the prior art, a load of 1400 kg/size A4 (sheet width: 210mm) is required. The precondition in this case is that the thickness of the photosensitive sheet should be 30 micrometers, and the thickness of the receiver sheet should be 115 micrometers, so that the thickness of the pressure receiving material comprised of the photosensitive sheet and the receiver sheet should be 145 micrometers.

However, when the respective diameters of the top, intermediate and bottom pressure rollers 310a, 310b, 310c are 40mm. 5mm amd 40mm respectively as in this embodiment, the load is 600 kg/ the width of an A4 sheet (110mm) on the similar precondition to the prior art, so that the load is less than half that occurring in the prior art.

According to the experiment, the diameter ∅ of at least one of the pressure rollers in contact with the pressure-receiving material 010, 701 preferably ranges from 3mm to 15mm for maintaining image quality. If the top, intermediate and bottom pressure rollers have diameters ∅ of 40mm, 3mm and 40mm, respectively, the load is 400 kg/ the width of an A4 sheet (210mm) and thus less than one third that occurring in the prior art. Thus, the load is substantially decreased. However, if intermediate pressure roller 310b has a diameter of less than 3mm, the developed sheet is susceptible to wrinkling, displacement, jamming and so on because of problems in the transporation system. Moreover, variations in the precision of the parts of the apparatus and minor movements of the apparatus may cause an unstable load on the pressure-receiving. material 010, 701 so that a predetermined quality of image is not obtained. When the top, intermediate and bottom pressure rollers have diameters ∅ of 40mm, 15mm and 40mm, respectively, the load is 900 kg. the width of an A4 sheet (210mm) which is less than 3/4 of that occurring in the prior art. However, if the intermediate pressure roller 310b has a diameter ∅ greater than 15mm, the load reduction rate is low and hence the initial object is not achieved.

The respective pressure rollers may be made of the materials referred to in Section 26 of the Japanese Industrial Standard (JIS) as SK4 material or S45C material. These materials may have the following compositions.

| Composition | Carbon tool steel SK4 (JIS) | Tool steel for machine structure S45C (JIS) |
|---|---|---|
| C | 0.90 – 100% | 0.42 – 0.48 |
| Si | < 0.35 | 0.15 – 0.35 |
| Mn | < 0.50 | 0.60 – 0.90 |
| P | < 0.030 | < 0.030 |
| S | < 0.030 | 0.035 |

These materials may be processed by lathe-machining into the predetermined size to ensure an hardness of HRC 60-65 through thermal treatment, and then, may be completed to have a surface roughness of Rmax 3.5-5$\mu$mm and a cylindricity of 15 $\mu$mm through an abrasion process. That is to say, the extent to which the product varies from a perfect cylinder does not exceed 15$\mu$mm. Further, a hard chromium plated layer of 50$\mu$mm may be applied to the material and then the thickness of the hard chromium plated layer may be reduced to 40$\mu$mm through another abrasion process. As a result, the surface of this layer is uniformly smoothed. The hard plate layer is required for improving the wear resistance and damage resistance of the pressure roller. A material with an hardness of less than HRC60 is poor in damage resistance and a material with a hardness of more than HRC 65 is liable to crack. If the surface roughness is reduced to less than Rmax 3.5mm, there is no difference in image quality. This value is the lower limit from the economical point of view. If the surface roughness is greater than Rmax 5$\mu$mm, since the diameter of the microcapsules is 3-10 $\mu$mm, there is an unevenness in load applied on the microcapsules at the pressure developing time with the result that the microcapsules are not uniformly broken. This reduces the image quality. The requirement for the cylindricity of 15 $\mu$mm depend on similar reasons.

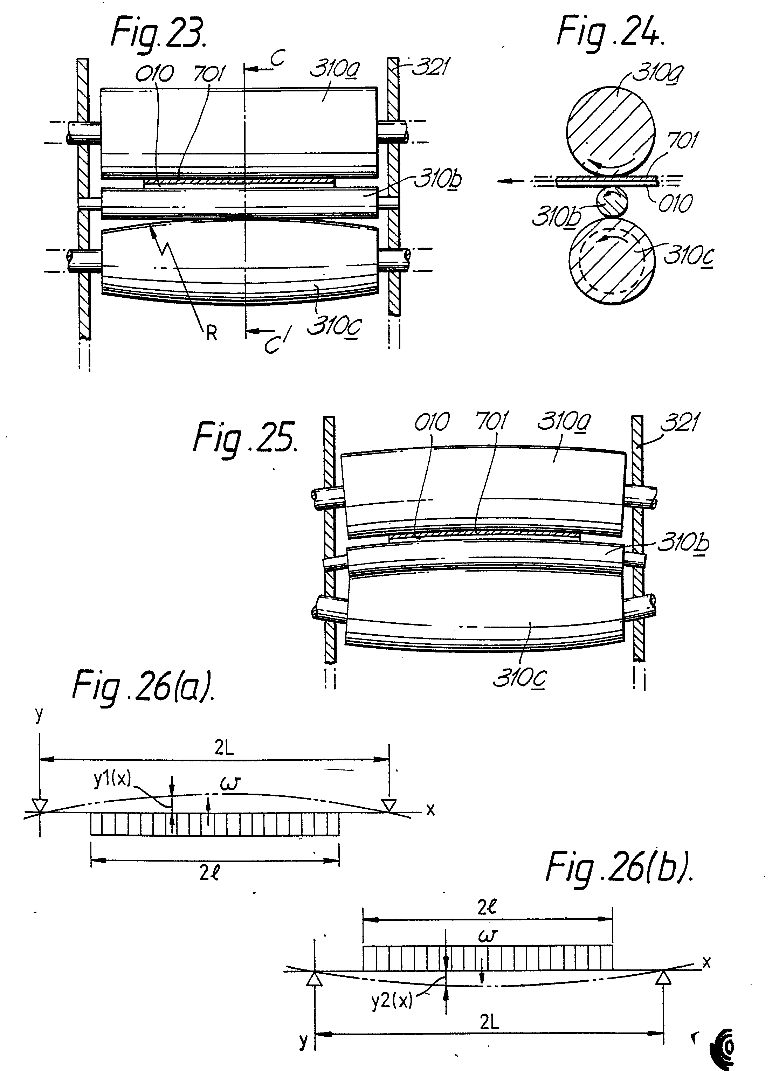

The shape of the bottom pressure roller required for applying a uniform pressure is now described in detail with reference to Figures 23-25. Figure 23 is a sectional view of respective pressure rollers, Figure 23 showing the condition where the top end of the receiver sheet 701 is inserted into the pressure developer immediately before the pressure development; Figure 24 is a sectional view taken along the line C-C′ of Figure 23; and Figure 25 is a sectional view of respective pressure rollers, Figure 25 showing the condition where the pressure developmentis carried out.

In Figures 23-25, reference numeral 310a denotes a top pressure roller which is a drive shaft and has a diameter ∅ 40 mm 6n the pressure developing part. Reference numeral 310 b denotes an intermediate pressure roller with a diameter of 5 mm on the pressure developing part. The intermediate pressure roller 310b presses the photosensitive medium 010 and the receiver sheet 701 against the top pressure roller 310a to form an image on the receiver sheet 701. Reference numeral 310c′ denotes a bottom pressure roller which has a configuration with a curvature R and also has a maximum outside diameter of ∅ 40mm. The bottom pressure roller 310c ′ moves up and down with the intermediate pressure roller 310b mounted on the bottom pressure roller 310c′, and supports the intermediate pressure roller 310b from the back to prevent the deformation thereof. Reference numeral 321 denotes support plates for supporting the respective pressure rollers.

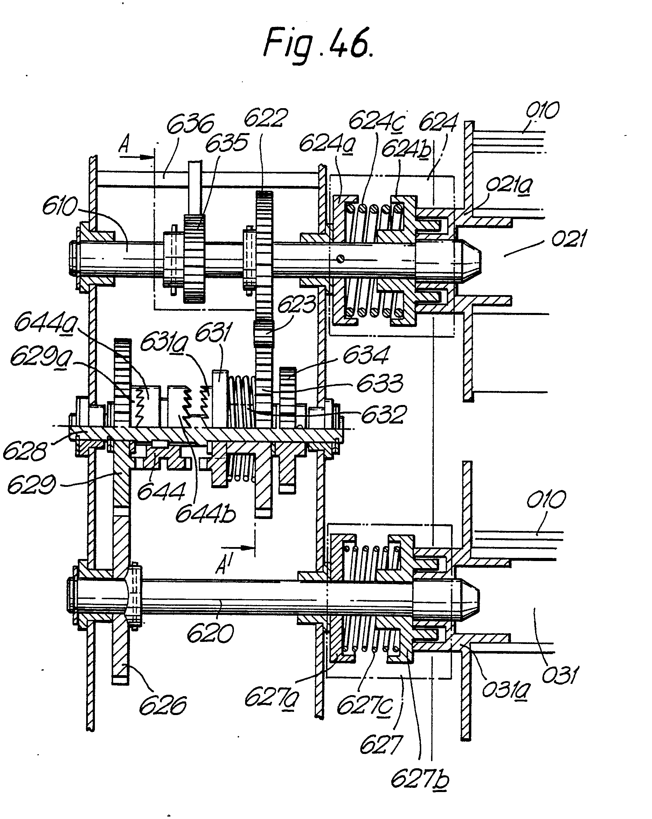

The pressure developer shown in Figures 23-225 is characterized in that the pressure developing part of intermediate pressure roller 310b has a smaller diameter than the pressure developing part of the top pressure roller 310a, and the pressure developing part of the bottom pressure roller 310c′ has a configuration with a curvature R. The curvature R is determined such that each pressure roller will be deformed to a predetermined extent at the pressure development time. The bottom pressure roller 310c′ is so designed that the distribution of the load applied to the pressed materials is uniform.

The way in which the curvature R is determined is described below with reference to Figures 26(a), 26-(b), and 26(c). The resultant curvature is shown in Table 1.

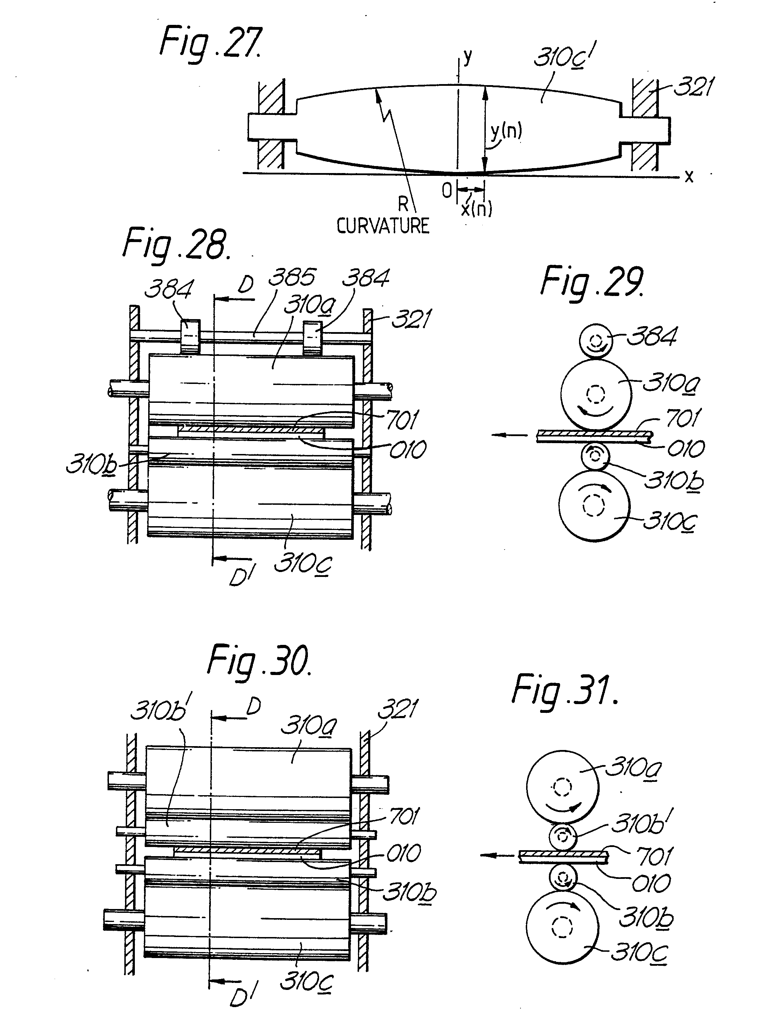

Figure 26(a) is a schematic view showing the condition where the load is applied to the top pressure roller 310a at the pressure development time. Figure 26(b) is a schematic view showing the condition where the load and the configuration applied to the intermediate pressure roller 310b is taken together with the load on a bottom pressure roller 310c having a straight configuration. Figure 27 is a sectional view of a bottom pressure roller 310 c′ having a configuration with a curvature R which has been calculated. At the pressure development time, the load is applied in equal distribution across the width of a receiver sheet, to the top pressure roller 310a with respect to both its support points which are its engagement points with the support plates 321. Accordingly, the top pressure roller 310a is deformed by a displacement amount of $y_1$-(x) as shown by a two-dot-and-dash line in Figure 26(a) Likewise, the intermediate and bottom pressure rollers 310b, 310c, which are assumed to act as one, are deformed by a respective displacement amount of $y_2(x)$ as shown by a two-dot-and-dash line in Figure 26(b). The respective displacement amount is calculated (the calculation process being omitted here) and is exchanged to the outside diameter $y(n)$ of the bottom pressure roller 310c′ at the point $x(n)$. This exchanged value and the approximately determined curvature R are shown in Table 1

## Table 1

| x(n) mm | y(n) mm | curvature Rmm | Note |
|---------|---------|---------------|------|
| 0.0 | 40.000 | approximate | calculation condition: |
| 10.0 | 39.998 | value: | E(Young's modulus): $2.1 \times 10^4$ |
| 20.0 | 39.993 | 62600 | kgf/mm$^2$; W(equally distributed |
| 30.0 | 39.984 | | load): 3.7 kgf/mm; |
| 40.0 | 39.971 | | D1 (top pressure roller |
| 50.0 | 39.956 | | diameter): $\phi$ 40 mm; |
| 60.0 | 39.932 | | D2 (intermediate pressure |
| 70.0 | 39.916 | | roller diameter): $\phi$ 5 mm; |
| 80.0 | 39.891 | | D3 (bottom pressure roller |
| 90.0 | 39.865 | | diameter): $\phi$ 40 mm; |
| 100.0 | 39.837 | | 2L (distance between |
| 110.0 | 39.808 | | fulcrums): 256 mm; and |
| 115.0 | 39.793 | | 21 (sheet width): 216 mm |

Another embodiment of the structure of the pressure rollers is now described below with reference to Figures 28-9.

Figure 28 is a schematic view of the pressure rollers and Figure 29 is a sectional view taken along line D-D' of Figure 28.

In the construction of Figures 28 and 29, pressure roller 310a which is a drive shaft, has a pressure part with a diameter $\phi$ of 30 mm. An intermediate pressure roller 310b has a pressure part with a diameter $\phi$ of 10mm and is supported from the back by the top pressure roller 310a to prevent deformation thereof. A bottom pressure roller 310c, which has a pressure part with a diameter of 19 mm, is moved up and down with the intermediate pressure roller 310b mounted on the bottom pressure roller 310c so that the intermediate pressure roller 310b is supported to prevent the deformation thereof. Support plates 321 serves to support all the pressure rollers. Two rollers 384 are stationarily mounted on a support shaft 385 fixed above the top pressure roller 310a and spaced therefrom. The rollers 384 are adapted to prevent the deformation of the top pressure roller 310a so as to achieve a uniform pressure.

In the above structure, at the pressure development time, the load is applied to the shafts located at the opposite ends of the bottom pressure roller 310c, whereby a uniform load is applied in the width direction of the receiver sheet 701. This uniform load is achieved by virtue of the fact that the load received from the two rollers 384 and the deformation curve of the top pressure roller 310a derived from the distributed load received from the receiver sheet 701 substantially conform to the load applied through the shafts located at the opposite ends of the bottom pressure roller 310c and the deformation curve of the bottom pressure roller 310c derived from the distributed load. The respective rollers 384 for achieving the uniform load are preferably situated respectively in the vicinity of 44 mm from the centre of the pressure rollers if the receiver sheet 701 has a width of 210 mm. The structure of the pressure rollers, other than in respect of the features described above, is similar to that of the pressure rollers of the embodiment shown in Figures 23-25 and hence, further description is omitted.

A further embodiment of the pressure rollers is described now with reference to Figures 30-31.

Figure 30 is a schematic view of the pressure rollers of the pressure developer, and Figure 31 is a sectional view taken along the line D-D' of Figure 30.

In the construction of Figures 30 and 31, a top pressure roller 310a which is a drive shaft, has a pressure part with a diameter ⌀ of 40 mm. An intermediate pressure roller 310b ' has a pressure part with a diameter of 10 mm and is backed up by a top pressure roller 310a so as to prevent deformation thereof. Reference numeral 310b indicates another intermediate pressure roller which has a pressure part with a diameter of ⌀ 10 mm. The intermediate pressure roller 310b applies pressure to the photosensitive medium 010 and receiver sheet 701, which are supported against the intermediate pressure roller 310b' to form an image on the receiver sheet 701 as it is fed through. A bottom pressure roller 310c, which has a pressure part with a diameter ⌀ of 40 mm, is moved up and down with the intermediate pressure roller 310b mounted on the bottom pressure roller 310c and supported thereby so as to prevent the deformation thereof. Support plates 321 serve to support all the pressure rollers.

This embodiment is characterised in that each of the intermediate pressure rollers 310b ' and 310b have a pressure part with a diameter smaller than that of either the top pressure roller 310a or the bottom pressure roller 310c, the rollers 310b' 310 being disposed between the top and bottom pressure rollers 310a and 310c. Thus, four pressure rollers are employed. According to this embodiment, the load is reduced to less than half and a uniform distribution of the load over the pressure-receiving material is achieved. The structure of the pressure rollers shown in Figures 30-31 apart from the above points, is similar to that shown in Figures 23-25 and hence, the description thereof is omitted.

According to the preceding embodiments, at least one of a plurality of pressure rollers in contact with the pressure-receiving material composed of the photosensitive medium 010 and the receiver sheet 701 has a smaller diameter than others, whereby the contact area between the pressure-receiving material 010, 701 and the pressure rollers is decreased so that the load used for pressure development is substantially reduced. The reduction in load allows a decrease in the rigidity of the pressure parts of the respective pressure rollers and thus the pressure developer is reduced in size and weight. In addition, each of the pressure rollers in contact with the pressure-receiving material 010, 701 is mounted on another pressure roller which has a greater diameter than the former roller and is supported at its back to prevent the deformation of the small-diameter pressure roller. Accordingly, a uniform distribution of the load imposed on the pressure-receiving material is attained, thereby providing a high quality image.

## Speed of the pressure development

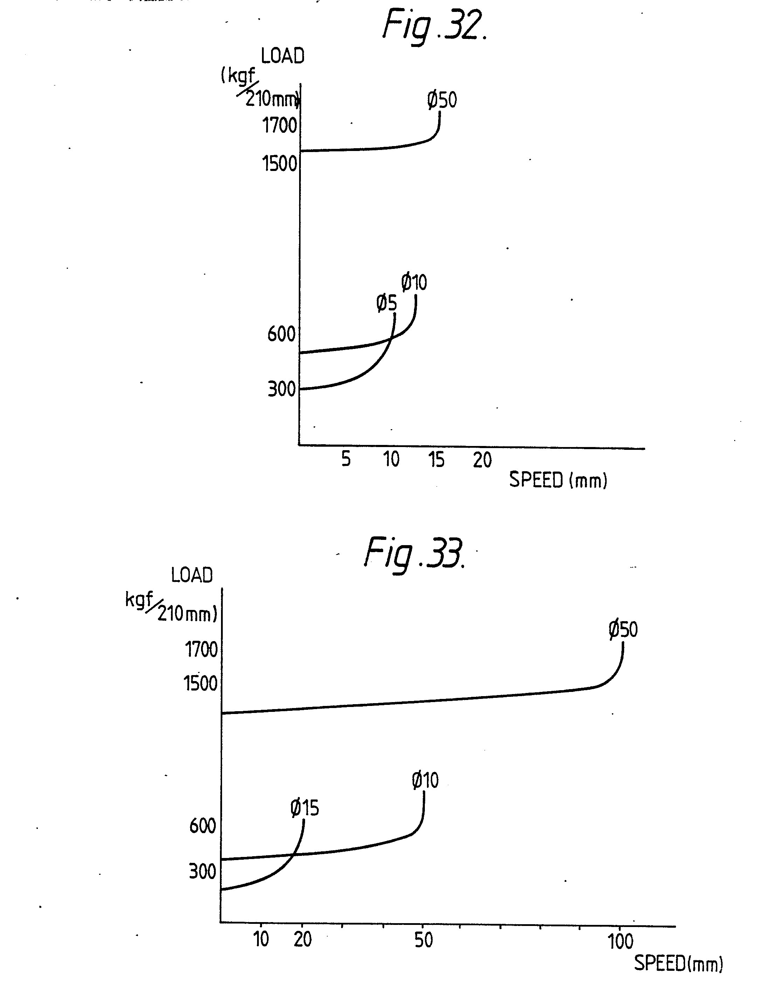

The relationship between the diameter of a pressure roller, the load applied to a pressure roller and the speed at which the photosensitive medium 010 and receiver sheet 701 are fed under pressure is now described with reference to Tables 2, 3, and Figures 32-34. Hereinafter, the value of the load is indicated as applied to the width of an A4 sheet, namely 210mm.

## Table 2

| Pressure Roller Diameter | Speed | | Load |
|---|---|---|---|
| 5 (mm) | (1) | 10 (mm/sec.) | 600 (kgf/210 mm) |
| | (2) | 20 | |
| 10 | (1) | 12.5 | 700 |
| | (2) | 50 | |
| 50 | (1) | 15 | 1700 |
| | (2) | 100 | |

## Table 3

| Pressure Roller Diameter | Speed | | Load |
|---|---|---|---|
| 5 (mm) | (1) | 1 (mm/sec.) | 300 (kgf/210 mm) |
| 10 | (1) | 2.5 | 500 |
| 50 | (1) | 12.5 | 1600 |

Tables 2 and 3 indicate the result of a test wherein two pressure rollers, each having a diameter ⌀ of 5mm, another two pressure rollers each having a diameter ⌀ of 10mm, and a further two pressure rollers each having a diameter ⌀ of 50mm were respectively used for pressing and feeding the photosensitive medium 010 and the receiver sheet 701, and the respective relationship between the speed and the load was examined.

There are two cases in the preceding embodiments. In one case, the photosensitive medium 010 and the receiver sheet 701 are sandwiched between and fed under pressure by two pressure rollers which are different in diameter. In the other case, the photosensitive medium 010 and the receiver sheet 701 are sandwiched between and fed under pressure by two pressure rollers which are the same in diameter. However, according to the experiment, if the diameter of one pressure roller in contact with the pressure-receiving material 010, 701 is the same as that of the smaller diameter roller of the other pressure rollers, the relationship between the speed and the load is similar to the relationship seen in the case where the two pressure rollers are of different diameters. Accordingly, two pressure rollers which are the same in diameter were used in this test.

In Table 2, in the case of two pressure rollers each having a diameter ⌀ of 5mm, the photosensitive medium 010 and receiver sheet 701 may be fed at a speed of 10 mm/sec. shown at (1) under a load equal to or greater than 600 kg/210mm so as to achieve an optical reflection density equal to or greater than 2 in the complete image as well as a substantially maximum sheet feed speed. Further, the photosensitive medium 010 and receiver sheet 701 can be fed at a speed of 20 mm/sec, shown at (2) under a load equal to or greater than 600 kg/210mm so as to achieve a substantially maximum sheet feed speed as well as an image quality without unevenness in density even if the optical reflection density is less than 2. As regards the optical reflection density (please see the optical term A41 in Japan Industrial Standard), the optical reflection density on a black ground is 2.2 and hence, an optical reflection density equal to or greater than 2 allows a sufficient colour density in an image.

A similar indication occurs in the case of two pressure rollers each having a diameter $\phi$ of 10 mm and in the case of two pressure rollers each having a diameter $\phi$ of 50mm. Namely, so as to achieve a substantially maximum sheet feed speed as well as an optical reflection density equal to or greater than 2, the photosensitive medium 010 and receiver sheet 701 may be fed at respective speeds of 12.5mm/sec. and 15mm/sec. shown at (1) under respective loads equal to or greater than 700 kg/210mm and equal to or greater than 1700 kg/210mm in respective cases.

Further, in order to achieve a substantially maximum sheet feed speed as well as an image quality without unevenness in density, the photosensitive medium 010 and receiver sheet 701 may be fed at respective speeds of 50mm/sec. and 100mm/sec. shown at (2) under respective loads equal to or greater than 700 kg/210mm and equal to or greater than 1700 kg/210mm in respective cases.

Table 3 shows the feed speed with the object of achieving a substantially minimum load as well as an optical reflective density equal to or greater than 2. For example, in the case of two pressure rollers each having a diameter $\phi$ of 5mm, when the load is 300 kg/210mm, the feed speed should be equal to or less than 1mm/sec. shown at (1).

Graphs based on the test results shown in Tables 2 and 3 are shown in Figures 32-34.

Figure 32 is a graph showing the relationship between the respective speeds shown at (1) in Tables 2 and 3, and the respective loads in the respective cases of two rollers having diameters $\phi$ of 5mm, 10mm, and 50mm. In this graph, the respective curves end with a sharp rising portion which, however, may be extended in the same inclination thereafter. That is, the speed is little changed. As is apparent from this graph, in order to achieve an optical reflection density equal to or greater than 2 in an image, the substantially maximum feed speed is 10mm/sec., 12.5mm/sec., and 15mm/sec, respectively in the respective cases of two pressure rollers having diameters $\phi$ of 5mm, 10mm and 50mm, no matter how much the load is.

Reference is now made to Figure 33 which is a graph showing the relationship between the respective speeds shown at (2) of Table 2, and the respective loads in the respective cases of two rollers having diameters $\phi$ of 5mm, 10mm, and 50mm. In this graph, the respective curves end with sharp rising portions which, however, may be extended in the same inclination thereafter. That is, the speed is little changed. As is apparent from this graph, in order to achieve an image quality without unevenness in density, the substantially maximum feed speed is 20 mm/sec., 50mm/sec., and 100mm/sec., respectively in the respective cases of two pressure rollers having diameters $\phi$ of 5mm, 10mm, and 50mm, no matter how much the load is.

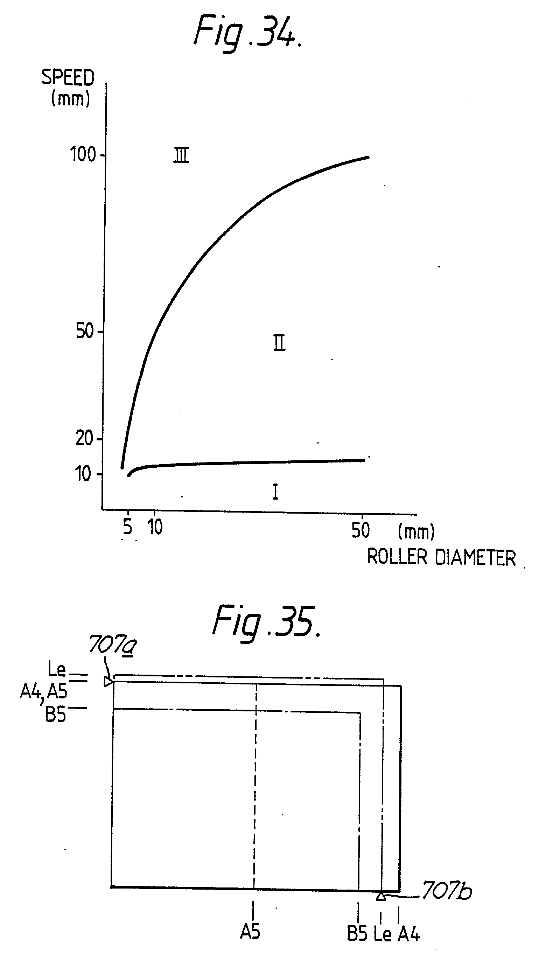

Reference is now made to Figure 34 which is a graph showing the diameter of the respective pressure rollers and the feed speed when the maximum load is applied. In this graph, the optical reflection density in an image is equal to or greater than 2 in the area I. However, in the area II, the optically reflective density of the image is less than s so that the colours are lighter. Further, in the area III, unevenness in density occurs.

From the preceding discussion it can be seen that when the photosensitive medium 010 and the receiver sheet 701 are sandwiched between and fed under pressure by two pressure rollers with the object of increasing the feed speed without decreasing the image quality, if the feed speed is 100 mm/sec. at a maximum, an image quality without unevenness is achieved. Moreover, if the feed speed is equal to or less than 15mm/sec., it is feasible to provide an image clear and sufficient in colour density.

As described above, if the photosensitive medium 010 and the receiver sheet 701 are fed at a speed of at most 100mm/sec., an high quality image without unevenness is formed.

The most general method of applying a pressure is the method using the pressure rollers as described above. However, another method can be employed if it is a matter of breaking non-hardened or softened microcapsules. In one such method the microcapsules are hit by an accelerated hammer and are broken by kinetic energy. In another method, softened microcapsules are broken by a supersonic wave which is adjusted to a vibrational energy capable of breaking softened microcapsules only.

## Receiver sheet container

As shown in Figure 1, the receiver sheet 701 is fed out from the receiver sheet cassette 702 by the pick-up roller 650 and is delivered to the pressure developer 300. The detection of the information as to what size of receiver sheet is contained in the receiver sheet cassette 702 is used as follows. First, if the scanning of an original picture which is to be used in connection with the exposure indicates a length allowing the image to be adapted to the size of the receiver sheet 701, the copying speed is increased.

18

Secondly, the pressure developer 300, which has a mechanism for opening or closing (i.e. effecting relative movement of) the pressure rollers at the times when the receiver sheet 701 is inserted into and fed out from the pressure rollers, is able to determine the opening timing without detecting the bottom end of the receiver sheet 701 if the size of the receiver sheet 701 is detected in advance.

One embodiment is now described below with reference to Figures 35-38 as to the use of detectors 70a and 70b for detecting respective sizes of the receiver sheet cassette 702 and the receiver sheet 701.

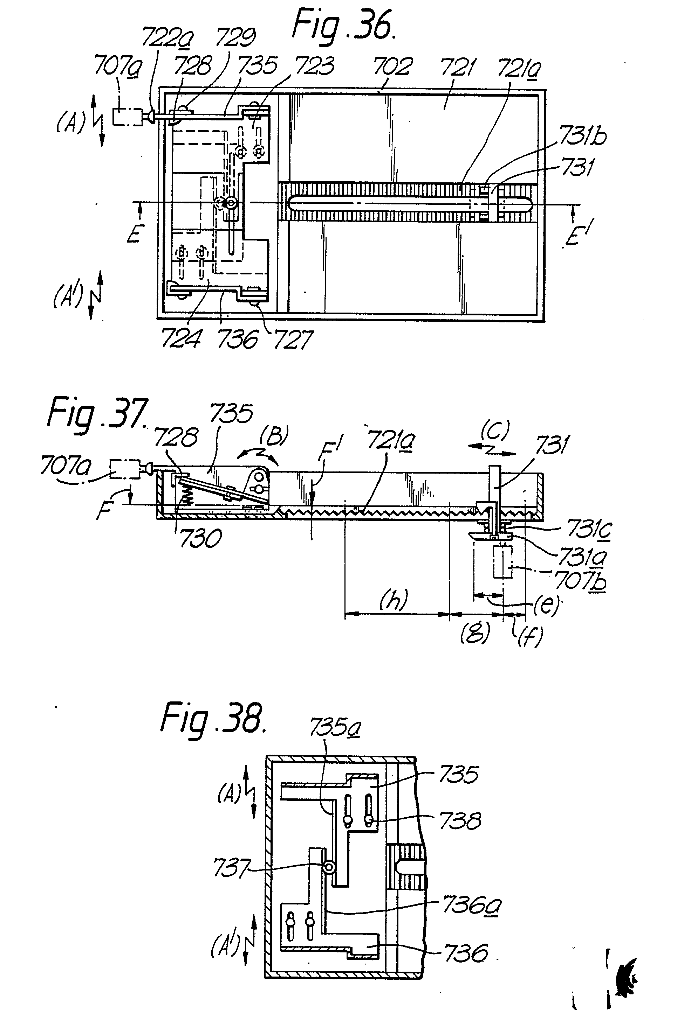

Figure 35 is a plan view showing the sizes of four kinds of receiver sheet 701, Figure 36 is a plan view showing a receiver sheet cassette 702, Figure 37 is a sectional view taken along the line E-E′ of Figure 36 and also shows the positional relationship between the end of the receiver sheets 701 in the case of the four sizes thereof, together with detectors 707a, 707b, and Figure 38 is a sectional view taken on the line F-F′ of Figure 37.

In Figure 35, a dash line shows the size A5, a dot-and-dash line shows the size B5, a two-dot-and-dash line shows the letter size (hereinafter referred to as Le), and a solid line shows the size A4. Figure 35 shows their positional relationship when receiver sheets 701 of such sizes are set in contact with one side of the receiver sheet cassette 702. A reliable method of detecting the four sizes is to use three detectors which are arranged in the vertical direction and four detectors which are arranged in the lateral direction in Figure 35 according to the respective sizes. However, according to this embodiment, all the sizes are detected by two detectors only. In Figure 35, the triangle mark indicates detectors 707a and 707b, respectively.

There are also shown the positional relationship between the receiver sheets 701 and the detectors 707a, 707b when they are installed in the apparatus.

Table 4 shows the sizes of the receiver sheet 701 and their measurements, and whether there is a detector for it or not.

## Table 4

| Sheet Size | Sheet Measurement | | Detector Exists (o) or Not (x) | | Note |
|---|---|---|---|---|---|
| | Width $a$ (mm) | Length $b$ (mm) | a | b | |
| A4 | 210 | 297 | o | x | same signal as A5 |
| A5 | 148 | 210 | o | x | same signal as A4 |
| B5 | 182 | 257 | x | x | |
| Le | 216 | 280 | x | o | letter size |

The subcolumns $a$ and $b$ referred to in Table 4 above relate to the detectors 707 $a$, 707b respectively.

As shown in Figures 36 and 37, the detector 707a operates only when a sheet of A4 or A5 size paper is used. On the other hand, the detector 707b operates only when a sheet of Le size is used.

As seen in Table 4, since the same signal is generated in both the cases of the sizes A4 and A5 in the aforementioned conditions, either the size A4 or A5 corresponding to the detector 707b is rendered conductive with the detector 707b to generate the condition where the detector exists. Accordingly, respective separate signals corresponding to the four sizes of receiver sheet 701 are produced so that the four sizes are identified respectively.

The construction of the receiver sheet cassette 702 necessary to achieve the aforementioned condition is now described with reference to Figures 36-38. In Figures 36, 37 and 38, a receiver sheet cassette body 721 is shown having a convex-and-concave portion formed on the inner surface of the bottom thereof. Receiver sheet width positioning plates 735 and 736 are slidable in the directions of arrows (A) and (A′), and are adapted to position a receiver sheet 701 in the centre relative to the width of the receiver sheet cassette body 721. A plate 731 operates to position the receiver sheet 701 in the length direction. Reference numeral 728 denotes a receiver sheet holding-down pawl for positioning the upper position of the receiver sheet 701, reference numeral 737 indicates a pinion, and 707a , 707b are the detectors. The receiver sheet width positioning plates 735 and 736 are formed with rack portions 735a and 736a respectively, and grooves operating as guides at the time of sliding. In addition, the receiver sheet width positioning plates 735 and 736 are slidable in the directions of the arrows (A) and (A') in engagement with the pinion 737. Pins 738 are engaged with the above-mentioned grooves. In accordance with the above structure, the receiver sheet 701 is always· set in a central position relative to the sheet width direction of the receiver sheet cassette 702 even if the size of the receiver sheet 701 is changed. Therefore, if the receiver sheet cassette 702 is set in the apparatus so as to be positioned in the centre relative to the width of the photosensitive medium 010, it is possible to prevent the receiver sheet 701 from being displayed relative to the width of the photosensitive medium 010.

The pawl 728 is secured to the plates 735 and 736 by a pin 729. Thus the pawl 728 moves upwards and downwards with the plates 735 and 736.

The receiver sheet width positioning plate 735 is formed with a contact point member 722a protruding from the receiver sheet cassette body 721 in the upper position. When the receiver sheet width positioning plate 735 is slid to the position of the sheet width (length) of A4 or A5 paper as described hereinbefore, the contact point member 722a is brought into pushing contact with the detector 707a to thereby actuate the detector 707a. Plates 723, 724 are rotatably engaged with the receiver sheet width positioning plates 735, 736 and the side walls of the receiver sheet cassette body 721 through engaging pins 727. When the receiver sheet 701 has been set in position, the top surface of the receiver sheet 701 is held down by the receiver sheet holding-down pawl 728 rotatably attached to a receiver sheet width positioning plate 722 through an engaging pin 729. If receiver sheets 701 are used sequentially and the thickness of the stack is reduced, the uppermost receiver sheet 701 is always urged·down by the receiver sheet holding-down pawl 728 due to the force of a spring 730. A plate 731 for positioning the length of the receiver sheet 701 is slidable right and left. The plate 731 has below it a protruding portion 731 b which meshes with a convex-and-concave portion 721a of the receiver sheet cassette body 721 and is made stationary by the force of a spring 731c. Reference numeral 731a denotes a contact point member fixed to the receiver sheet length positioning plate 731 through a screw. If the plate 731 located in the position corresponding to the sheet length is slid to the right as seen in Figure 37 to the position of the size A4, the area (e) of contact point member 731a shown in Figure 37 ensures the length wherein the detector 707b is operable.

Accordingly, there is the relationship of (f) < (e) < (g) < (h) to prevent the signals of the size A4 and the size A5 being the same.

Table 5 below shows the relationship between sheet size and whether there is a detector for it or not.

## Table 5

| Sheet Size | Sheet Measurement· | | Detector Exists (O) or Not (X) | | Note |
|---|---|---|---|---|---|
| | Width (mm) | Length (mm) | a | b | |
| A4 | 210 | 297 | O | O | |
| A5 | 148 | 210 | O | X | |
| .B5 | 182 | 257 | X | X | |
| Le | 216 | 280 | X | O | Letter size |

In Figure 36, arrows (A), (A') indicate the directions in which the plates 723, 724 on which receiver sheets 701 are mounted are moved. In Figure 37 arrow (C) indicates the directions of movement of the receiver sheet length positioning plate 731, and arrow (B) indicates the directions of rotation of the plates 723 and 724 which are rotated around the engaging pin 727. The above structure allows very easy identification of four sizes of receiver sheet 701. The detectors 707a and 707b are micro-switches rendered conductive by the pushing force. As described above, the size of receiver sheet 701 is detected according to whether or not the contact point member pushes the detector (whether or not there is electric conduction), and a control circuit not shown detects the relationship between the size of the receiver sheet 701 and the feed speed of the photosensitive medium 010. As a result, current flows through the lamp for a necessary period of time so that the exposure time for the photosensitive medium 010 is determined.

As described above, the detectors 707a, 707b are provided for detecting the width and length of the receiver sheet 701, and the contact point members 722a, 731a for pressing the detectors 707a, 707b are disposed in the receiver sheet cassette, whereby the size of the receiver sheet 701 is detected when the receiver sheets are set in the receiver sheet cassette. As a result, the exposure time, namely, the lamp lighting time, is calculated from the relationship between the length of the receiver sheet 701 and the predetermined feed speed of the photosensitive medium 010. Accordingly, the photosensitive medium 010 is exposed for the predetermined time by the length required for forming an image on the receiver sheet 701. The above structure thus eliminates the problem of the photosensitive medium being unnecessarily exposed or the image being incompletely formed due to the exposure time being too short as in the prior art.

## Thermal treatment means

The image on the photosensitive medium 010 is developed and transferred to the receiver sheet 701 by the pressure developer 300 and then the receiver sheet 701 is fed through the thermal treatment means 400 to be heated thereby. This heating operation promotes the development reaction and also serves to solve problems caused by developer provided on the receiver sheet and a mixture of optical hardening matter, dye precursors projected from broken microcapsules and attached to the receiver sheet, or the like. As a result, the image-formed surface of the receiver sheet 701 becomes a glossy surface so that the image is given a good appearance and long-time preservation because of the use of a coating film.

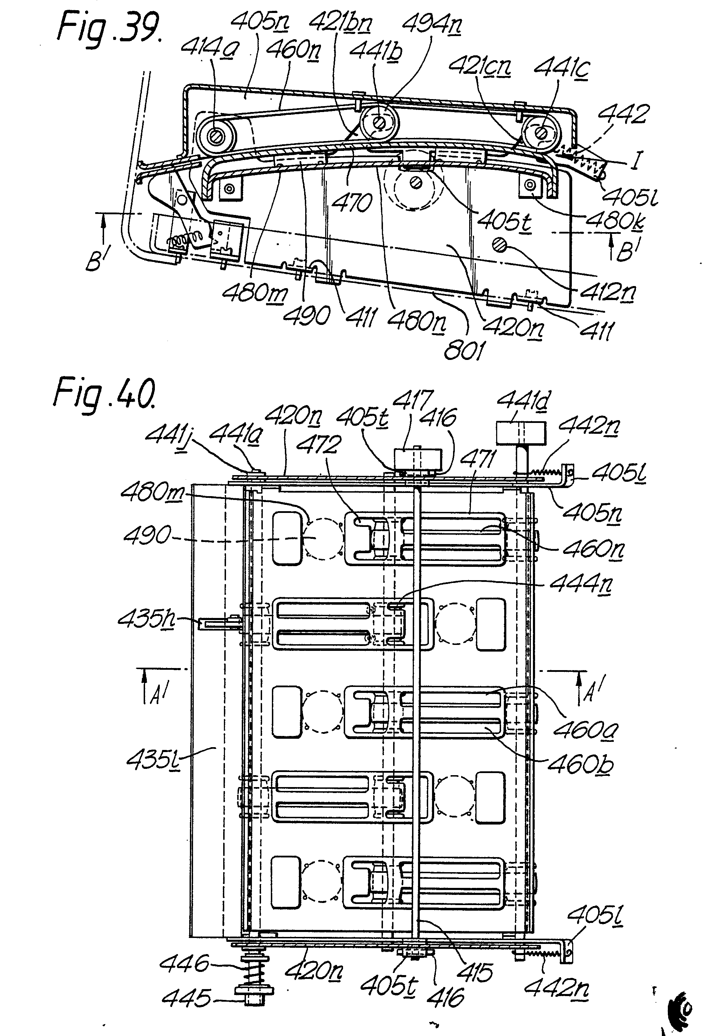

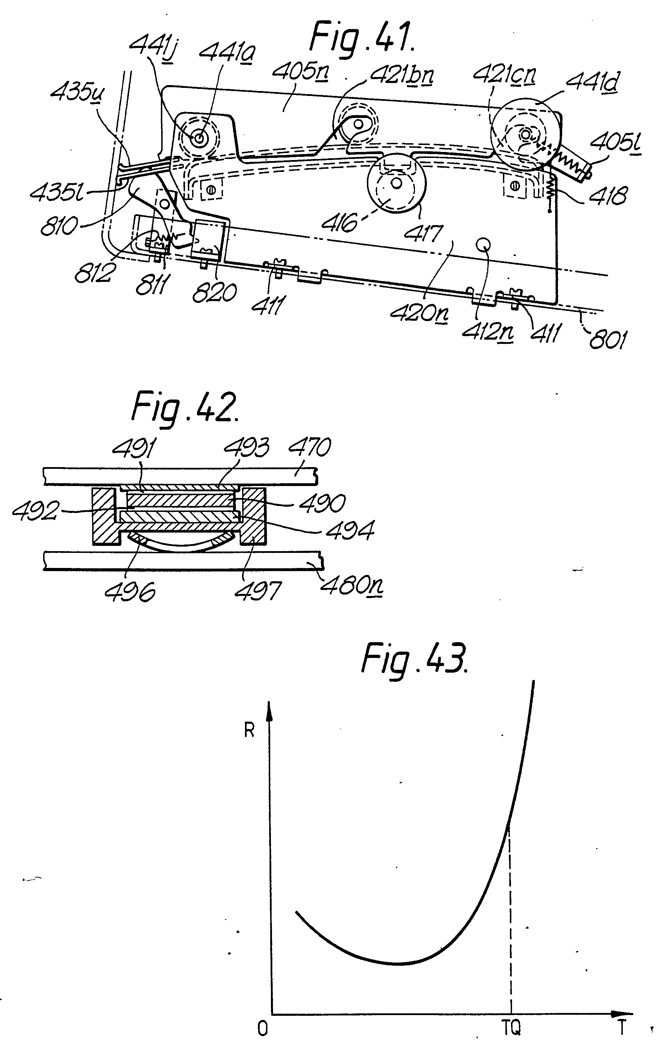

Figure 40 is a sectional view of a thermal treatment means 400 taken on the line B'-B' of Figure 39; Figure 39 is a sectional view taken on the line A'-A' of Figure 40; and Figure 41 is a side view of the structure shown in Figure 40.

In the embodiment of Figures 39-41, a heat plate 470 having a heater 490 is secured to a heat plate under plate 480n, both sides of which are secured to side plates 420n. The heater 490 is secured between the heat plate 470 and the plate 480n by a spring 496 as shown in Figure 42. Belt shafts 441b, 441c , which have rollers 444n provided with five belts 460 n for carrying the receiver sheet, are rotatably supported by an upper case 405n, the upper case 405n being opened or closed by a cam 455. Heat plate 470 and heat plate under plate 480n are fixed so that fixing feet 480k located in four positions of the heat plate under plate 480 are secured to the side plates 420 n by screws.

The construction of the heater 490 is shown in Figure 42. As shown in Figure 42, a heater 490 with electrodes 491, 492, a heat transfer sheet 493, and a sheet 494 are layered and contained in a recess formed on the upper surface of a heat resistant heater case 497. The heater case 497 with the heater 490 and so on is sandwiched between a heat body 470 and the heat plate under plate 480n and is made stationary by a belleville spring 496. The heater case 497 is positioned by positioning projections 480m - (Figure 40) provided on heat plate under plate 480n. Five heaters 490 are arranged in the left or right zone of the heat body 470 as shown in Figure 40. A positive thermal coefficient thermistor with electrodes 491, 492 on the top and bottom surfaces thereof is used for the heater 490. It is generally known that an increment of the temperature T causes a sharp rise in the resistance value R as shown in Figure 43. Accordingly, the positive thermal coefficient thermistor for TQ degree can provide the desired temperature (TQ degree) without using other temperature adjusting means. In this embodiment, a thermistor for TQ = 150-180°C is used. Side plates 420n are made stationary and reinforced by a coupling bar 412n (Figure 41) thereby preventing the mutual positional relationship of the of the side plates 420n being altered. On both the side walls of the upper case 405n , there are secured bearings 441j which rotatably support a roller shaft 441a. The outer circumferences of the bearings 441j are guided by a hole in the side plates 420n. The upper case 405n is pivotably mounted on the side plates 420n. Both side walls of the upper case 405n are formed with guide grooves 421bn, 421cn for regulating the vertical positions of belt shafts 441b , 441c . A roller 444n with a projecting part in the centre is made from heat resistant synthetic resin or metal with the surface on which non-slip process is applied. Rollers 444n are adhered to belt shafts 441a , 441b , 441 c . Five belts 460n are stretched between the rollers 444n The belts 460n are made from silicon resin and the like having heat resistance. Each belt 460n, which is tensioned on a roller 444n with a projecting part in the centre, is prevented from being removed from the roller and is moved stably by the projecting part.

A respective tension spring 442n is stretched between a right end portion 405ℓ provided on a side of the upper case 405n and a belt shaft 441c, thereby supplying belt 460 with tension force. The right end portion 405ℓ of the upper case 405 is located at a lower position than the guide groove 421 cn (Figure 39) and supplies guide shafts 441c, 441b with a component of force directed downwards as seen in Figure 39. In addition, guide grooves 421bn, 421cn have a width designed to be out of contact with the guide shafts 441c , 441b even if the belts 460n are close to the heat plate 470. Therefore, when the upper case 405n is closed, the five belts 460n contact the receiver sheet 701 and apply thereto an adequate pressure to carry the receiver sheet 701. When the upper case 405n is opened by the method described later on, the upper case 405n is lifted by the rim of the upper case 405n formed with the guide grooves 421bn, 421cn, thereby providing a space between the belt 460n and the heat plate 470.

The mechanism for opening the upper case 405n upwardly is next described. A cam shaft 415 (Figure 40) is rotatably supported by both side plates 420n. Disc cams 416 are attached to respective outer surfaces of the side plates 420n. A knob 417 for manually rotating cam shaft 415 is secured outside the disc cam 416 as shown in Figure 40. The upper case 405n is formed with a protruding piece 405t the bottom of which abuts on the disc cam 416. Accordingly, upon rotation of the knob 417, the disc cam 416 pushes up the protruding piece 405t so that the upper case 405n is opened. Since a respective tension spring 418 (Figure 41) is stretched between the upper case 405n and a side plate 420n, when a disc cam 455 is rotated to thereby provide a space between the disc cam 455 and the protruding piece 405t, the upper case 405n is closed by the tension force of the tension spring 418.

On one end of the belt shaft 441a there is mounted a spring clutch 446 (Figure 40) which is widely used. The spring clutch 446 has a gear 445 which meshes with an external power mechanism (not shown) and rotates the gear 445 at a somewhat higher speed than the receiver sheet feed speed in the pressure developer 300. The frictional torque of the spring clutch 446 supplies the receiver sheet 701 with an adequate tension and the receiver sheet 701 is carried forward.

Reference numeral 441d in Figure 40 denotes a knob for manually rotating a guide shaft 441. Since the knob 441d is coupled to the external power source through the spring clutch 446, in the case of trouble the knob 441d is rotated to thereby move the belts 460n freely so that receiver sheet 701 is carried forward.

A mechanism for detecting the passage of the receiver sheet 701 is now described. In Figure 41, reference numeral 810 denotes a movable strip. One end of movable strip 810 is positioned in a groove 435h (Figure 40) of a lower guide plate 435l provided at the outlet for the receiver sheet 701. The movable strip 810 is rotatably supported by a support member 811 fixed to a bottom plate 801, while the other end of the movable strip 810 is disposed in a photocoupler 820. The movable strip 810 is urged by a weak tension spring 812 so that one end of the movable strip 810 may be brought into contact with the upper guide plate 435u in the absence of a receiver sheet 701. In this case, the other end of movable strip 810 does not interrupt the light of the photocoupler 820. The photomultiplier 820 comprises an emission element (such as a light emitting diode) and an optical element (such as a photodiode) opposite to each other and with a gap therebetween. When the movable strip 810 moves in this gap, light is prevented from entering the emission element.

When the receiver sheet 701 is carried forward, the movable strip 810 is turned anti-clockwise so that its end interrupts the light of the photocoupler 820. Consequently, passage or non-passage of the receiver sheet 701 is detected. However, other methods also have a similar effect. For example, the receiver sheet 701 can be directly lit by the photocoupler and the amount of reflected light or transmitted light is examined so as to detect the passage or non-passage of the receiver sheet. Another example is that a detecting end of a microswitch can directly abut a receiver sheet to thereby detect the existence of the receiver sheet.

The receiver sheet 701 fed out from the pressure developer 300 is led by a guide plate 652 (Figure 1) and inserted between the heat plate 470 and belts 460n through the inlet in the direction of arrow I in Figure 39. Since the belts are moved at a slightly higher speed than the feed speed of the pressure developer 300 as described above, the receiver sheet 701 is drawn into the thermal treatment means 400 without slack. The receiver sheet 701 is carried forward by three belts 460n on the inlet side and by two belts 460n on the outlet side. Moreover, the heat plate 470 is slightly curved downwardly so that the receiver sheet 701 is carried forwardly with its rear surface attached to the surface of the heat plate 470. The top end of the receiver sheet 701 is carried into the thermal treatment means 400 by belts 460n extending near to the right hand end as shown in Figure 40, while the bottom end of the receiver sheet 701 is carried out of the thermal treatment means 400 by belts 460n extending near to the left hand end as shown in Figure 40. Accordingly, even a cut sheet with a small size can be subjected to thermal treatment. Furthermore, a hole 472 is provided between the heater 490 and a belt 460n, and also holes 460a, 460b are provided adjacent a belt 460n so that the heat generated by the heater 490 is cut down by these holes. Accordingly, the colour formers on the surface of the receiver sheet 701 can be prevented from being melted and attached to the belts 460.

The heater 490 is heated to 150-180°C, whereby the surface temperature of the heat plate 470 is kept at approximately 130°C. Therefore, even if the receiver sheet 701 is exposed to the heat at this temperature for a long time, it is not damaged in quality.

The colour formers, dye precursors, or the like for the formation of an image on the receiver sheet 701 have their viscosity decreased at approximately 100°C and are substantially melted.

According to test results, when the receiver sheet was heated at 130°C for five seconds, an image with a very good gloss was obtained. Additionally, when the receiver sheet was heated at a temperature ranging from 100°C to not more than 130°C, an image with a substantially good surface state was obtained. The upper limit of temperature was the temperature at which the substrate of the receiver sheet 701 is changed

22

in quality (about 200°C). The above-mentioned heating time (5 seconds or more) is the actual time period starting at the time when the temperature of the receiver sheet reaches the predetermined point. Therefore, the total time for carrying the receiver sheet through the thermal treatment means is longer than the above heating time. Thus the receiver sheet 701 is sandwiched and carried between the belts 460n and a part of heat plate 470 at a temperature lower than the melting point of the colour formers and the like. Further, the high-temperature part of the heat plate 470, excepting the above-mentioned low-temperature part, is uniformly contacted by the surface of the receiver sheet. As a result, the thermal treatment means promotes the colour forming reaction on the image formed on the surface of the receiver sheet and also causes the melting of the colour formers and the like. As a result, the surface of receiver sheet 701 becomes glossy and then, the receiver sheet 701 with the complete image is fed to the exterior.

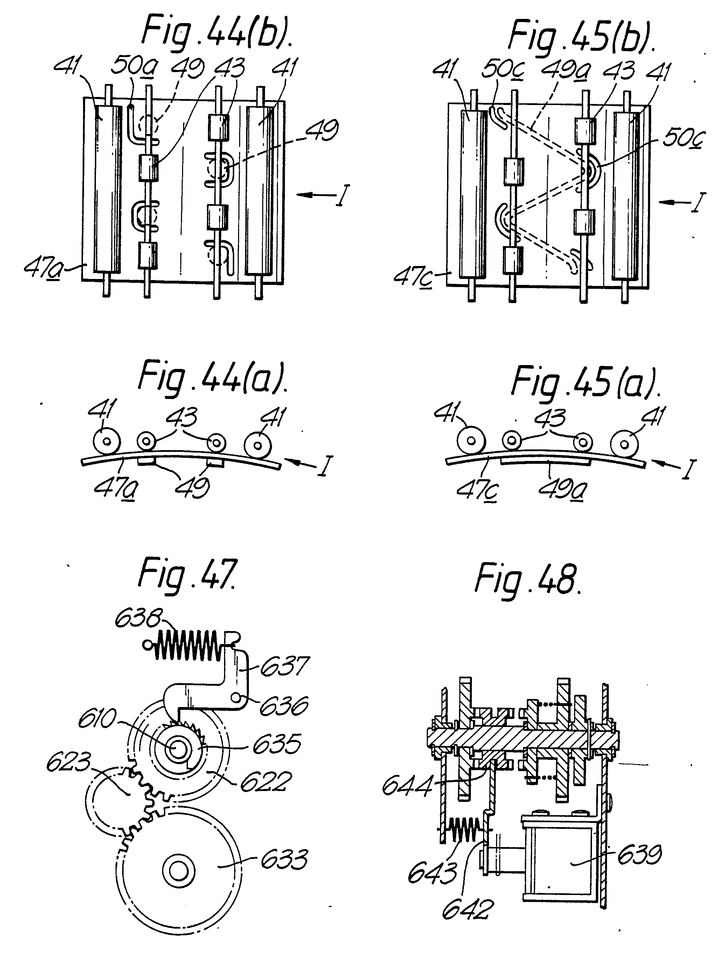

Reference is now made to Figures 44 and 45 which depict other embodiments. In these embodiments, the receiver sheet 701 is transported by rollers. In the above-mentioned embodiment, the receiver sheet 701 is carried forward by the belts 460n, and the belts 460n disposed on the inlet side and the belts 460n disposed on the outlet side overlap in the central part of the thermal treatment mechanism when they are seen from the side. Accordingly, even a receiver sheet with an extremely short length can be carried without failure. However, the embodiments described hereinbelow allow the transportation of the sheet only using rollers without belts and hence this simplifies the structure.

In Figures 44 and 45, reference numerals 47a, 47c denote heat plates each having heaters fixed to their bottoms. Heaters 43 shown in Figure 44 are similar to those described in the first embodiment. A heater 49a shown in Figure 45, which has a band-like form, is fixed on a zigzag line so as to avoid the positions of transporting rollers 43. Nickel-chromium wiring coated with heat resistant resin may be used for the band-like heater 49a.

Reference numeral 41 denotes rollers attached to drive shafts. The surface of each roller 41 is formed with small concavities and convexities so as to increase the frictional coefficient relative to the receiver sheet 701 and is made from silicon rubber or the like having a good heat resistance. Rollers 43 disposed inwardly of the rollers 41 bring the receiver sheet 701 into close contact with the heat plate 47a adjacent to the heaters 49 and also have the function of carrying the top and bottom ends of the receiver sheet 701 without failure.

In the part provided with the rollers 41, 43 near to the heaters 49, the heat plates 47a, 47c are formed with slits 50a, 50c respectively so as to decrease the temperature in this part, whereby the colour formers and the like on the surface of the receiver sheet 701 are prevented from being pressed in the softened or melted condition by the rollers 41, 43.

As described above the mechanism for carrying forward the receiver sheet 701 directly by means of the rollers 41, 43 allows a substantial simplification of the thermal treatment means. Further, the use of the band-like heater 49a allows a uniform temperature distribution in the heated area of the heat plate 47c so that an image with a uniform appearance is formed on the receiver sheet 701.

At least the image-formed area of the pressure-developed receiver sheet is thus heated by heating means to a temperature higher than the softening point of the materials for image formation. Further, the receiver sheet 701 is carried forward by driving means in contact with the non-softened area of the receiver sheet. Thus, the thermal treatment means has the following effects:

a) The receiver sheet 701 is heated to the predetermined temperature irrespective of the temperature of the embodiment in which the image forming apparatus is placed, so that the development reaction speed is increased and hence a good-quality image is obtained in a short time. Particularly in the case of colour image formation, an image with excellent colour balance is obtained.

b) The matter on the receiver sheet 701 for forming an image is heated to a temperature higher than the softening point of the said matter and is melted once, thereby producing a smooth surface. Then this matter is solidified while maintaining its smooth surface so that the surface of this receiver sheet is glossy. Thus an image with a clear appearance is obtained.

c) The surface of the receiver sheet 701 is smooth and has a minimum area in contact with the air so that the elements required for image formation are hardly affected by oxygen or by a variety of harmful gases present in the air and hence the image produced is long lasting.

d) Since the receiver sheet 701 is carried by means such that nothing contacts the softened area of the receiver sheet, the image is not damaged by the drive means and has a fair glossy surface.

## Driving mechanism

A driving mechanism for driving the respective mechanisms described above is described below mainly with reference to Figure 1.

The photosensitive medium 010, receiver sheet 701, and script table 500 are moved by a motor 380.

The take-up shaft 620 is engaged with storage shaft 032 of the cassette 001 for storing the photosensitive medium 010. The rewinding shaft 610 is engaged with the supply shaft 021 on the cassette 001. The drive from the motor 380 is transmitted to the take-up shaft 620 and rewinding shaft 610 through a spring clutch and a gear train respectively. The pressing contact roller 630, which is adjacent to the top pressure roller 310a which is rotated by the motor 380 through the photosensitive medium 010, is disposed in the passage between the top pressure roller 310a and the cassette 001. Upon energization of a solenoid, the drive from the motor 380 is transmitted to the pick-up roller 650 by the combination of a solenoid clutch (not shown) and a ratchet wheel(not shown). One receiver sheet 701 contained in the receiver sheet cassette 802 is led forward by the pick-up roller 650 for each rotation thereof and is delivered to the top pressure roller 310a.

The receiver sheet 701 fed into thermal treatment means 400 is carried at a slightly higher speed than the feed speed of the pressure developer 300 by the drive from the motor 336.

In this apparatus, at the exposure time, the pressing contact roller 630 is pressed against the top pressure roller 310a so that tension is applied to the photosensitive medium 010 by the spring clutch of the rewinding shaft 610 (Figure 46). Then the photosensitive medium 010 is transported at the same speed as the script table 500, contrary to the tension. When the receiver sheet 701 is transported into a position between the top and intermediate pressure rollers 310a and 310b by the pick-up roller 650 so as to be superposed on the latent image formed on the photosensitive medium 010, the motor 333 (Figure 9) for pressure development is rotated so as to apply a load to the top and intermediate pressure rollers, whereby the photosensitive medium 010 and the receiver sheet 701 are fed to the left while an image is developed by the pressure. After the pressure development, the photosensitive medium 010 is separated from the receiver sheet 701 by the separating mechanism 350 and is taken up by the storage shaft 031 shown in Figure 1, which is rotated by the drive from the motor 380.

Moreover, when the bottom end of the receiver sheet 701 is located between the top and intermediate pressure rollers 310a and 310b, it is detected by a detecting roller 140 for detecting the extent of feed of the photosensitive medium 010. In response to the detection, the motor 333 for the pressure is rotated, whereby the intermediate pressure roller 310b is separated from the top pressure roller 310a. At this time, the receiver sheet 701 reaches the thermal treatment means 400 by moving over the guide member 652. Subsequently, the colour forming reaction occurring on the receiver sheet 701 is promoted by the thermal treatment means 400 and the surface of the receiver sheet 701 is given a gloss. The receiver sheet 701, with the complete image formed thereon, is then fed out from the apparatus.

The bottom end of the latent image formed on the photosensitive medium 010 is located between the top pressure roller 310a and the intermediate pressure roller 310b when the latent image is transferred to the receiver sheet 701 by the pressure development. Accordingly, as described above, the load is removed from the intermediate pressure roller 310b and the receiver sheet 701 is transported forward. When the receiver sheet 701 is completely separated from the photosensitive medium 010, the pressing contact roller 630 is moved out of contact with the top pressure roller 310a. At the same time, the rewinding shaft 610 is rotated anti-clockwise, whereby the aforementioned bottom end of the photosensitive medium 010 is rewound up to the exposure table 130.

As regards the rewinding of the non-exposed part of the photosensitive medium 010, the rewinding time is calculated from the relationship between a predetermined distance and the transportation speed by a control system not shown. When the reverse rotation of the supply shaft 021 is started in response to the output, the photosensitive medium 010 is rewound during the outputted rewinding time and is then stopped.

The above transportation system prevents the non-exposed part of the photosensitive medium 010 being discarded uselessly, resulting in the effective use of the photosensitive medium.

As described above, one power source, namely the motor 380, causes the transportation of the photosensitive medium 010 and receiver sheet 701 so that there is a simple structure such that the image forming apparatus is unlikely to have quality problems.

A mechanism and a pressing contact roller for rotating a supply roller around which non-used photosensitive medium is wound and a take-up roller for taking up used photosensitive medium are next described with reference to Figures 46-48.

Figure 46 is a sectional view of a mechanism for rotating the supply roller and the take-up roller, Figure 47 is a sectional view taken along the line A-A' of Figure 46 and Figure 48 is a bottom plan view of Figure 47.

In Figures 46-48, reference numeral 021 denotes the supply shaft around which non-used photosensitive medium 010 is wound, 021 a is a boss attached to the supply shaft 021, 031 is the storage shaft which takes up used photosensitive medium, and 031a is a boss attached to storage shaft 031. A rewinding shaft 610, take-up shaft 620, a driving shaft 628 and a ratchet shaft 636 (Figure 47) are relatively rotatably mounted in the apparatus body through bearings. A gear 622, a coil spring clutch 624 and a ratchet 635 are mounted on the rewinding shaft 610. A gear 626 and a coil spring clutch 627 are mounted on the take-up shaft 620. A gear 629, an engaging plate 631 and a gear 633 are rotatably mounted on the driving shaft 628. Further, a meshing or dog clutch 644 is slidably mounted on the driving shaft 628 for axial movement. A driving gear 634 is fixedly mounted on the driving shaft 628. A planet gear 623 is in mesh with both the gear 622 and the gear 633 so that the rewinding shaft 610 is rotated in the same direction as the driving shaft 628. Boss portions 624a and 627a of the coil spring clutches 624 and 627 are fixedly mounted on the rewinding shaft 610 and take-up shaft 620, respectively. Boss portions 624b and 627b of the coil spring clutches 624 and 627 are formed with projecting portions which are fitted into holes formed in the bosses 021a, 031a and are also acted on by coil springs 624c, 627c, respectively., Since the wire diameter of the coil spring 624c is arranged to be greater than that of the coil spring 627c, the rotational torque (T1) of the supply shaft 021 is greater than the rotational torque (T2) of the storage shaft 031. An engaging plate 642 has one end engaged with the meshing or dog clutch 644 and the other end engagingly attached to a solenoid 639 attached to a fixed part of the apparatus. Moreover, since a spring 643 is attached between the engaging plate 642 and the fixed part of the apparatus, a meshing part 644a of the meshing or dog clutch 644 is always in mesh with a meshing part 629a of the gear 629 so that the gear 629 can drive the take-up shaft 620 through the gear 626.

Upon actuation of the solenoid 639, the meshing or dog clutch 644 is moved to the left as seen in Figure 48 via the engaging plate 642 so as to bring the meshing part 644b into mesh with a meshing part 631a of a meshing plate 631, whereby the rewinding shaft 610 can be driven. The gear 633 and the engaging plate 631 are biased by a spring 632. As shown in Figure 47, a ratchet pawl 637 is rotatably mounted on the ratchet shaft 636 and has a pawl portion on one end thereof. The pawl portion of ratchet pawl 637 is arranged to mesh with the ratchet 635, while the other end of the ratchet pawl 637 is engaged by a spring 638, so that the rewinding shaft 610 shown in Figure 47 is rotatable clockwise and is not rotatable anti-clockwise. A meshing or dog clutch 644 and coil spring clutches 624, 627 are used in this embodiment. However, other clutches, such as a friction clutch, a cone clutch, a centrifugal clutch, or an electromagnetic clutch, may be used instead.

The pressing contact roller 630 (Figure 1) is rotatably mounted on a rotatable shaft 630a which is itself rotatably mounted in the vicinity of the pressing contact roller 630.

The pressing contact roller 630 is mounted on a arm 630b which is coupled to the rotatable shaft 630a as shown in Figure 1.

The arm 630b, to which a spring 630c is attached, is urged in the direction of an arrow O around the rotatable shaft 630a to thereby urge the pressing contact roller 630 into contact with the top pressure roller 310a. Furthermore, a slide part (not shown) of the solenoid 639 is attached to the arm 630b. Therefore, during the operation of the solenoid 639, the arm 630b is turned in the direction of an arrow N around the rotatable shaft 630a to thereby move the pressing contact roller 630 out of contact with the top pressure roller 310 a. When a photosensitive medium 010 is sandwiched between and pressed by the pressing contact roller 630 and the top pressure roller 310a, the pressing contact roller 630 is automatically rotated in the direction of an arrow G by the frictional force to thereby feed the photosensitive medium 010.

Reference is now made to the rotational torque of the respective rollers in transporting the photosensitive medium 010. If the rotational torque of each of the supply shaft 021, storage shaft 031, pressing contact roller 630, and intermediate pressure roller 310b is T1, T2, T3, T4, respectively, the relationship therebetween in rotational torque is as follows:-

(1) T1 > T2

(2) T1 < T2 + T3

(3) T1 < T2 + T4

The relationship (1) is due to the fact that the spring pressure of the coil spring 624, which is provided inside the coil spring clutch 624 mounted on the rewinding shaft 610, is greater than the spring pressure of coil spring 627c which is provided inside the coil spring clutch 627 mounted on the take-up shaft 620. The relationship (2) is due to the fact that the spring 630c operating on the pressing contact roller 630 is arranged to have a pressure such as to ensure the torque difference (T1-T2). The relationship (3) is due to the fact that the application spring 335 operating on the intermediate pressure roller 310b is arranged to have a pressure such as to ensure the torque difference (T1-T2).

The following is a detailed description of the above relationships along the transportation passage of the photosensitive medium 010. When a non-used photosensitive medium 010 is set and started, the take-up shaft 610 is rotated in the direction of the arrow C, while the pressing contact roller 630 is rotated in the direction of the arrow 0 so as to press the photosensitive medium 010 against the top pressure roller 310a . As a result, the pressing contact roller 630 rotates in the direction of the arrow G, whereby the rotational torque T2 + T3 is generated. The supply shaft 021 is prevented from rotating in the direction of the arrow B by the ratchet 635 and the ratchet pawl 637, so that the rotational torque T1 which operates as a brake because of the pressure of the coil spring clutch 624 is applied to the supply shaft 021. Accordingly, the photosensitive medium 010 is drawn from the photosensitive medium cassette 001 and is transported by the rotational torque (T2+T3-T1) up to the pressing contact roller 630. The photosensitive medium 010 is then taken up by the rotational torque T2. Immediately afterwards, the exposed photosensitive medium 010 is superposed on the receiver sheet 701 and the two are inserted into the space provided between the pressure rollers 310a, 310b. The intermediate pressure roller 310b is then moved in the direction of the arrow M to thereby press the pressure-receiving material 010, 701 against the top pressure roller 310a. Thus the pressure development is carried out as the two materials 010, 701 are fed in the direction of the arrow F by the top and intermediate pressure rollers 310a and 310b .

Simultaneously with the pressing effected by intermediate pressure roller 310b, the pressing contact roller 630 is rotated in the direction of the arrow N to move out of contact with the top pressure roller 310a so that the used photosensitive medium 010 is not pressed against the top pressure roller 310a by the pressing contact roller 630. Accordingly, the photosensitive medium 010 is fed from the photosensitive medium cassette 001 to the pressure rollers 310a, 310b by the rotational torque (T2+T4-T1), and is then taken up by the rotational torque T2.

Then, immediately before the bottom end of the receiver sheet 701 is fed out of the pressure rollers 310a, 310b, the intermediate pressure roller 310b starts moving in the direction of the arrow L so as to remove the pressure. Immediately after the bottom end of the receiver sheet 701 has been fed out from the pressure rollers 310a , 310b, each roller stops rotating. Immediately, the solenoid 639 is actuated to move the meshing or dog clutch 644 to the right as seen in Figure 46. Thus, the supply shaft 021 is rotated in the direction of the arrow B to generate the torque T1 so that the non-exposed part S of the photosensitive medium is rewound as shown in Figure 1. During this time, the storage shaft 031 stands still and the rotational torque T2 which operates as a brake by the pressure of the coil spring clutch 627 is applied to the storage shaft 031. Accordingly, the photosensitive medium 010 is rewound around the supply shaft 021 by the rotational torque (T2-T1) and is ready for the next image formation (exposure).

As described above, the apparatus comprises means for effecting rotation of the supply shaft 021 and storage shaft 031 and the plurality of clutches 644, 624, 627; the pressure roller 310 a which is moved into or out of contact with the photosensitive medium 010 and the receiver sheet 701 for pressure development; and the pressing contact roller 630 which is moved into or out of contact with the photosensitive medium 010 for transporting the same. Therefore, if the respective rotational torques of the supply shaft 021, storage shaft 031,pressing contact roller 630 and pressure roller 310a for transporting the photosensitive medium 010 is T1, T2, T3, T4, respectively, the following relationship is achieved:-

(1) T1 > T2

(2) T1 < T2 + T3

(3) T1 < T2 + T4

From this relationship, the non-used photosensitive medium 010 is stably transported and the used photosensitive medium 010 is taken up by the storage shaft 021. In addition, the non-exposed part of the photosensitive medium 010 which has passed through the exposing mechanism is rewound by the supply shaft 021 to be used again, so that the photosensitive medium 010 is effectively used without wasting it.

The non-pressure-developed part of the photosensitive medium 010 is guided at its rear surface,(i.e. the surface opposite to the microcapsule-formed surface),by the exposure table 130 and the top pressure roller 310a, and is transported by the driving force of the top pressure roller 310a. The transporting system is thus out of contact with the microcapsule-formed surface of the photosensitive medium 010 during the transportation of the photosensitive medium, whereby the microcapsules formed on the photosensitive medium 010 are not subjected to external damage so that a high quality image can be formed without either damage or eneveness in density on the receiver sheet 701.

In addition, no special guide roller is required for transporting the photosensitive medium 010 so that a less expensive and smaller image forming apparatus can be provided.

## Claims

1. Image forming apparatus comprising first storage means (001) for storing a photosensitive medium (010) having rupturable capsules which contain material part of which is adapted to form an image and part of which, on exposure to light, alters the hardness or softness of the capsules; exposing means (100) for exposing the photosensitive medium (010) to a predetermined light pattern; second storage means (702) for storing a receiver sheet (701) which is to receive the said image; and pressure means (300) for rupturing selected capsules so as to produce an image on the receiver sheet (701).

2. Image forming apparatus as claimed in claim 1 characterised in that the first storage means (001) is provided with a supply shaft (021) around which unexposed photosensitive medium (010) may be wound; a lightproof cartridge (040) within which the supply shaft (021) is mounted ; a storage shaft (031) around which exposed photosensitive medium (010) may be wound; driving means (628) for driving the supply shaft (021) and storage shaft (031); and a cassette case body (070) within which are mounted the storage shaft (031) and cartridge (040).

3. Image forming apparatus as claimed in claim 2 characterised in that the driving means comprises a driving shaft (628) which drives the supply shaft (021) and the storage shaft (031) by way of respective clutches (644, 624,627).

4. Image forming apparatus as claimed in claim 2 or 3 characterised in that an U-shaped member (080), for supporting a loop of the photosensitive medium (010), is itself supported by and protrudes from the cassette case body (070).

5. Image forming apparatus as claimed in any preceding claim characterised in that the pressure means (300) in operation presses the photosensitive medium (010) against the receiver sheet (701) so that the latter receives the image.

6. Image forming apparatus as claimed in claim 5 characterised in that the pressure means (300) comprises at least one pair of pressure rollers (310a, 310b).

7. Image forming apparatus as claimed in claim 6, characterised in that one pressure roller (310b) of the or each said pair of pressure rollers(310a, 310b) has a smaller diameter than the other (310a).

8. Image forming apparatus as claimed in claim 6 or 7 characterised in that at least one of the pressure rollers (310a, 310b) is engaged or engageable with a back-up roller (310c).

9. Image forming apparatus as claimed in any of claims 6-8 characterised in that relative movement effecting means (310d, 326) are provided for effecting relative movement towards and away from each other of pressure rollers (310a, 310b) between which the photosensitive medium (010) and the receiver sheet (701) may be passed.

10. Image forming apparatus as claimed in claim 9 characterised in that the pressure means (300) comprises a detector (314) which is arranged to detect the presence of a predetermined portion of the receiver sheet (701), the said detector 314) controlling operation of the relative movement effecting means (310d, 326).

11. Image forming apparatus as claimed in claim 9 or 10 characterised in that the relative movement effecting means effect relative movement of plates (321'a , 321'b) in which the pressure rollers (310'a, 310'b) are rotatably mounted.

12. Image forming apparatus as claimed in claim 9 or 10 characterised in that at least one of the pressure rollers (310'a) is supported by plates (321'a, 321'b) at least one of which is removable to assist introduction of the photosensitive medium (010) into the pressure means (300).

13. Image forming apparatus as claimed in any preceding claim characterised in that the second storage means (702) is provided with detector means (707a, 707 b) for detecting the width and length of the receiver sheet (701), the detector means (707a, 707b) controlling the length of the exposure.

14. Image forming apparatus as claimed in any preceding claim characterised in that a thermal treatment means (400) is provided for thermally treating the receiver sheet (701) which has received the said image.

15. Image forming apparatus as claimed in claim 14 characterised in that, in operation, the thermal treatment means (400) is arranged to heat at least the image-formed area of the receiver sheet (701) to a temperature higher than the softening point of the matter forming the image.

16. Image forming apparatus as claimed in claim 15 characterised in that there are driving means (460n) for transporting the receiver sheet (701) through the thermal treatment means (400) in contact,with the non-softened area of the receiver sheet (701).

17. An image forming apparatus wherein a photosensitive medium (010) having thereon microcapsules each containing at least an optically hardening or softening matter and a colour former is superposed on a receiver sheet (701) before or after exposing the photosensitive medium (010), and then, the exposed photosensitive medium (010) and the receiver sheet (701) are pressed against each other for the development of an image, comprising:

a photosensitive medium container (001) for storing said photosensitive medium (010);

an exposing means (130) for exposing said photosensitive medium (010);

a receiver sheet container (702) for storing said receiver sheet (701);

a pressure developer means (300) for applying a pressure to said photosensitive medium (010) and receiver sheet (701) for development; and

a thermal treatment means (400) for thermally treating said receiver sheet (701) having a developed image.

18. An image forming apparatus wherein a photosensitive medium (010) having thereon microcapsules each containing at least an optically hardening or softening matter and a colour former is superposed on a receiver sheet (701) before or after exposing the photosensitive medium (010), and then, the exposed photosensitive medium (010) and receiver sheet (701) are pressed against each other for the development of an image, comprising:

a photosensitive medium container (001) for storing said photosensitive medium (010);

an exposing means (130) for exposing said photosensitive medium (010);

a receiver sheet container (702) for storing said receiver sheet (701);

a pressure developer means (300) having a pair of pressure rollers (310a, 310b) for pressing a pressure-receiving material comprised of said photosensitive medium (010) and said receiver sheet (701) for development, said pressure developer means (300) including a mechanism (310d, 326) for moving said pressure rollers (310a, 310b) into and out of contact with each other.

19. An image forming apparatus wherein a photosensitive medium (010) having thereon microcapsules each containing at least an optically hardening or softening matter and a colour former is superposed on a receiver sheet (701) before or after exposing the photosensitive medium (010) and then, the exposed photosensitive medium (010) and receiver sheet (701) are pressed against each other for the development of an image, comprising:

an exposure table (130) on which said photosensitive medium (010) is exposed for forming a latent image thereon and which guides said photosensitive medium (010) on the rear surface reverse to the microcapsule-provided surface; and

a pressure roller (310a) rotated for applying a pressure to a pressure-receiving material comprised of said photosensitive medium (010) and said receiver sheet (701) for development, the rear surface reverse to the microcapsule-provided surface of said photosensitive medium (010) being guided in contact with the outer circumferential surface of said pressure roller (310a),

said photosensitive medium (010) being guided on the rear surface reverse to the microcapsule-provided surface by at least said exposure table (130) and said pressure roller (310a) and transported by the driving force of said pressure roller (310a) up to said pressure roller for pressure development.

# Fig .1.

0 263 609

**Fig.2.**

510  520  500  521  505 561 501  571

572

380

701

**Fig.3.**

400  445  501  310a(300) 572  571/380

701  702

110(100)

001  500

## Fig.4.

## Fig.5.

0 263 609

Fig.6.

## Fig. 7.

044'

027

040

043

031

010

021

026

044

072'

076

071'

077

072

052a

075

071

078

070

052a

W

## Fig. 8.

310a

010

701

310b

A

Fig.9.

Fig.9a.

0 263 609

Fig.10.

345

340    344  341
           342
                343  320
                        321

347
346

Fig.11.

342    320
           340
               343.
               310a
               310b
               339
               310c
               325
               326
               310d
               334
               335
               336
               337
               338

θ

321

0 263 609

Fig.12.

326

336

338

321

329    334    335    337

Fig.13.

321a

310a

310b

321b

310c

321c

321

Fig .14.

310d

331

332

333

Fig .15.

310a

314

010

310b

701

310c

326

332b

332a

331

Fig .16.

T

TORQUE

T2

T1

T0

A  B  C  D          E  F  G

t

TRANSPORTATION
TIME

Fig. 17.

0 263 609

## Fig.18.

Fig.19.

Fig.20.

Fig.21.

Fig.22.

0 263 609

## Fig.23.

010  701  C  310a  321
310b
R  C'  310c

## Fig.24.

310a
701
010
310b
310c

## Fig.25.

010  701  310a  321
310b
310c

## Fig.26(a).

$y$
$2L$
$y1(x)$  $\omega$
$x$
$2\ell$

## Fig.26(b).

$2\ell$
$\omega$
$x$
$y2(x)$
$2L$
$y$

Fig.27.

Fig.28.

Fig.29.

Fig.30.

Fig.31.

# Fig.32.

LOAD (kgf/210mm)

# Fig.33.

LOAD kgf/210mm)

## Fig.34.

SPEED
(mm)

III

II

I

ROLLER DIAMETER

## Fig.35.

707a

Le
A4, A5
B5

707b

A5        B5 Le A4

## Fig. 36.

## Fig. 37.

## Fig. 38.

## Fig. 39.

405n  421bn  494n
414a  460n  441b  421cn  441c
442
I
405l
470  405t  480k
B'  B'
480m  412n
490  411  480n  420n  411
801

## Fig. 40.

441j  441a  420n  405t  417  416  441d  442n
472  471  405l
480m  405n
490  460n
444n
435h
A'  A'
460a
460b
435l
405l
446  420n  405t  415  442n
445  416

# Fig.41.

# Fig.42.

# Fig.43.

Fig.44(b).

Fig.45(b).

Fig.44(a).

Fig.45(a).

Fig.47.

Fig.48.

# Fig.46.